# EUROPEAN PATENT APPLICATION

(11) **EP 4 726 785 A1**
(43) Date of publication of application: **15.04.2026**
(21) Application number: 24819439.1
(22) Date of filing: 15.01.2024
(51) Int. Cl.: H01L 33/44, H01L 33/20, H01L 33/38, H01L 25/075, H01L 27/15

(54) **LIGHT-EMITTING DEVICE AND DISPLAY DEVICE COMPRISING SAME**

(30) Priority: 08.06.2023 KR 20230073721
(71) Applicant: Samsung Display Co., Ltd., Yongin-si, Gyeonggi-do 17113 (KR)
(72) Inventor: SIM, Young Chul, Yongin-si, Gyeonggi-do 17113 (KR); KIM, Dae Hyun, Yongin-si, Gyeonggi-do 17113 (KR); KIM, In Hyuk, Yongin-si, Gyeonggi-do 17113 (KR); SEO, Dong Kyun, Yongin-si, Gyeonggi-do 17113 (KR); YOO, Chul Jong, Yongin-si, Gyeonggi-do 17113 (KR); JIN, Tae Ha, Yongin-si, Gyeonggi-do 17113 (KR); CHOI, Hyeong Su, Yongin-si, Gyeonggi-do 17113 (KR)
(74) Representative: Marks & Clerk LLP
(86) International application number: PCT/KR2024/000683
(87) International publication number: WO 2024/253285

(57) **Abstract**

A display device includes a first electrode and a second electrode which are spaced apart from each other on a substrate. A light emitting element is disposed between the first electrode and the second electrode. A light emitting element core of the light emitting element includes a first semiconductor layer, a second semiconductor layer spaced apart from the first semiconductor layer, and a light emitting layer disposed between the first semiconductor layer and the second semiconductor layer. A first element insulating layer surrounds a side surface of the light emitting element core. The first element insulating layer is an oxide insulating layer having a single crystalline structure.

## Description

### Technical Field

The disclosure generally relates to a light emitting element and a display device including the same.

### Background Art

As interest in information displays and demand for portable information media increase, research and commercialization has focused on display devices.

It is to be understood that this background of the technology section is, in part, intended to provide useful background for understanding the technology. However, this background of the technology section may also include ideas, concepts, or recognitions that were not part of what was known or appreciated by those skilled in the pertinent art prior to a corresponding effective filing date of the subject matter disclosed herein.

### Detailed Description of Invention

### Technical Problem

Embodiments provide a light emitting element having improved element efficiency and reliability and a display device including the light emitting element.

### Technical Solution

In accordance with an aspect of the disclosure, there is provided a light emitting element that may include a light emitting element core including a first semiconductor layer; a second semiconductor layer spaced apart from the first semiconductor layer; and a light emitting layer disposed between the first semiconductor layer and the second semiconductor layer; and a first element insulating layer surrounding a side surface of the light emitting element core, wherein the first element insulating layer is an oxide insulating layer having a single crystalline structure.

A thickness of the first element insulating layer in a direction perpendicular to the side surface of the light emitting element core may be greater than about 0 nm and is about 10 nm or less.

The first element insulating layer may include a metal oxide including two or more metal elements.

The two or more metal elements may be at least one selected from the group consisting of Ta, Hf, Zr, La, Si, Ti, and Al.

The first element insulating layer may include a first metal element. At least a portion of the light emitting element core may include a base element. A bond-dissociation energy of an oxide with respect to the first metal element may be greater than a bond-dissociation energy of an oxide with respect to the base element.

An ionic radius of the first metal element in the oxide may be greater than an ionic radius of the base element in the oxide.

The first element insulating layer may be directly disposed on the side surface of the light emitting element core.

The light emitting element may further include a second element insulating layer surrounding an outer side surface of the first element insulating layer.

The second element insulating layer may be an oxide insulating layer having an amorphous structure or a polycrystalline structure.

The first element insulating layer and the second element insulating layer may include a same material.

The light emitting element may further include a third element insulating layer surrounding an outer side surface of the second element insulating layer.

The first element insulating layer may have a superlattice structure in which a first layer and a second layer including different materials are alternately multi-stacked. The first layer and the second layer may be stacked in a direction perpendicular to the side surface of the light emitting element core.

Each of the first layer and the second layer may be an oxide insulating layer having a single crystalline structure.

A thickness of each of the first layer and the second layer in a direction perpendicular to the side surface of the light emitting element core may be greater than about 0 nm and is about 10 nm or less.

In accordance with another aspect of the disclosure, there is provided a display device that may include a first electrode and a second electrode, disposed on a substrate; the first electrode and the second electrode, being spaced apart from each other; and a light emitting element disposed between the first electrode and the second electrode, wherein the light emitting element includes a light emitting element core including a first semiconductor layer; a second semiconductor layer spaced apart from the first semiconductor layer; and a light emitting layer disposed between the first semiconductor layer and the second semiconductor layer; and a first element insulating layer surrounding a side surface of the light emitting element core, and the first element insulating layer is an oxide insulating layer having a single crystalline structure.

The first element insulating layer may have a thickness which is greater than about 0 nm and is about 10 nm or less in a direction perpendicular to the side surface of the light emitting element core.

The first element insulating layer may include a metal oxide including two or more metal elements.

The two or more metal elements may be at least one selected from the group consisting of Ta, Hf, Zr, La, Si, Ti, and Al.

The light emitting element may further include a second element insulating layer surrounding an outer side surface of the first element insulating layer. The second element insulating layer may be an oxide insulating layer having an amorphous structure or a polycrystalline structure.

The first element insulating layer may have a superlattice structure in which a first layer and a second layer including different materials are alternately multi-stacked. The first layer and the second layer may be stacked in a direction perpendicular to the side surface of the light emitting element core. Each of the first layer and the second layer may be an oxide insulating layer having a single crystalline structure.

### Advantageous Effects

In the light emitting element in accordance with the disclosure, an oxide insulating layer having a single crystalline structure directly surrounds a side surface of a light emitting element core including semiconductor layers. The light emitting element core can have an effect that the light emitting element core is surface-treated, and surface defects of the light emitting element core can be prevented and reduced. The oxide insulating layer can prevent impurities from being diffused into the light emitting element core, and accordingly, the element efficiency and reliability of the light emitting element can be improved.

### Description of Drawings

The above and other aspects and features of the disclosure will become more apparent by describing in detail embodiments thereof with reference to the attached drawings, in which:
FIG. 1 is a schematic perspective view of a light emitting element in accordance with embodiments.
FIG. 2 is a schematic sectional view illustrating an embodiment of the light emitting element shown in FIG. 1.
FIG. 3 is a schematic sectional view illustrating an embodiment of the light emitting element shown in FIG. 1.
FIG. 4 is a schematic sectional view illustrating an embodiment of the light emitting element shown in FIG. 1.
FIG. 5 is a schematic sectional view illustrating an embodiment of the light emitting element shown in FIG. 1.
FIG. 6 is an enlarged view of area P shown in FIG. 5.
FIG. 7 is a schematic sectional view illustrating an embodiment of the light emitting element shown in FIG. 1.
FIG. 8 is a schematic sectional view illustrating an embodiment of the light emitting element shown in FIG. 1.
FIGS. 9 and 10 are schematic perspective views of a light emitting element in accordance with an embodiment.
FIGS. 11 to 17 are process sectional views illustrating a manufacturing method of the light emitting element shown in FIG. 1.
FIG. 18 is a schematic plan view of a display device in accordance with an embodiment.
FIG. 19 is a schematic plan view illustrating an embodiment of a pixel included in the display device shown in FIG. 18.
FIG. 20 is a schematic sectional view illustrating an embodiment of the pixel taken along line I-I' shown in FIG. 19.
FIG. 21 is an enlarged schematic sectional view illustrating an embodiment of area Q shown in FIG. 20.
FIG. 22 is an enlarged schematic sectional view illustrating an embodiment of the area Q shown in FIG. 20.
FIG. 23 is an enlarged schematic sectional view illustrating an embodiment of the area Q shown in FIG. 20.
FIG. 24 is an enlarged schematic sectional view illustrating an embodiment of the area Q shown in FIG. 20.

### Modes of the Invention

The disclosure may apply various changes and forms, thus, the disclosure includes given examples. However, the examples are not limited to that which is disclosed but apply to all changes and equivalents. Example embodiments will now be described more fully hereinafter with reference to the accompanying drawings; however, they may be embodied in different forms and should not be construed as limited to the embodiments set forth herein. Rather, these embodiments are provided so that this disclosure will be thorough and complete, and will fully convey the scope of the example embodiments to those skilled in the art.

In the drawing figures, dimensions may be exaggerated for clarity of illustration. It will be understood that when an element is referred to as being "between" two elements, it can be the only element between the two elements, or one or more intervening elements may also be present. Like reference numerals refer to like elements throughout.

As used herein, the singular forms, "a," "an," and "the" are intended to include the plural forms as well, unless the context clearly indicates otherwise.

In the specification and the claims, the term "and/or" is intended to include any combination of the terms "and" and "or" for the purpose of its meaning and interpretation. For example, "A and/or B" may be understood to mean "A, B, or A and B." The terms "and" and "or" may be used in the conjunctive or disjunctive sense and may be understood to be equivalent to "and/or."

In the specification and the claims, the phrase "at least one of" is intended to include the meaning of "at least one selected from the group of" for the purpose of its meaning and interpretation. For example, "at least one of A and B" may be understood to mean "A, B, or A and B."

It will be understood that, although the terms "first", "second," etc. may be used herein to describe various elements, these elements should not be limited by these terms. These terms are only used to distinguish one element from another element. Thus, a "first" element discussed below could also be termed a "second" element without departing from the teachings of the disclosure.

It will be further understood that the terms "comprises," "comprising," "includes," and/or "including,", "has," "have," and/or "having," and variations thereof when used in this specification, specify the presence of stated features, integers, steps, operations, elements, components, and/or groups thereof, but do not preclude the presence or addition of one or more other features, integers, steps, operations, elements, components, and/or groups thereof.

Further, an expression that an element such as a layer, region, substrate or plate is placed "on" or "above" another element indicates not only a case where the element is placed "directly on" or "just above" the other element but also a case where a further element or elements is/are interposed between the element and the other element.

On the contrary, an expression that an element such as a layer, region, substrate or plate is placed "beneath" or "below" another element indicates not only a case where the element is placed "directly beneath" or "just below" the other element but also a case where a further element is interposed between the element and the other element.

The terms "overlap" or "overlapped" mean that a first object may be above or below or to a side of a second object, and vice versa. Additionally, the term "overlap" may include layers, stacks, surfaces or faces, extensions, coverings, partial coverings or any other suitable term as would be appreciated and understood by those of ordinary skill in the art.

When an element is described as 'not overlapping' or 'to not overlap' another element, this may include that the elements are spaced apart from each other, offset from each other, or set aside from each other or any other suitable term as would be appreciated and understood by those of ordinary skill in the art.

The terms "face" and "facing" mean that a first element may directly or indirectly oppose a second element. In a case in which a third element intervenes between the first and second element, the first and second element may be understood as being indirectly opposed to one another, although still facing each other.

In the entire specification, when an element is referred to as being "connected" or "coupled" to another element, it can be directly connected or coupled to the another element or be electrically connected or coupled to the another element with one or more intervening elements interposed therebetween. The term "connection" between two components may include both electrical connection and physical connection.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

Unless otherwise defined or implied herein, all terms (including technical and scientific terms) used herein have the same meaning as commonly understood by one of ordinary skill in the art to which the disclosure pertains. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Hereinafter, a display device in accordance with embodiments of the disclosure will be described with reference to the accompanying drawings.

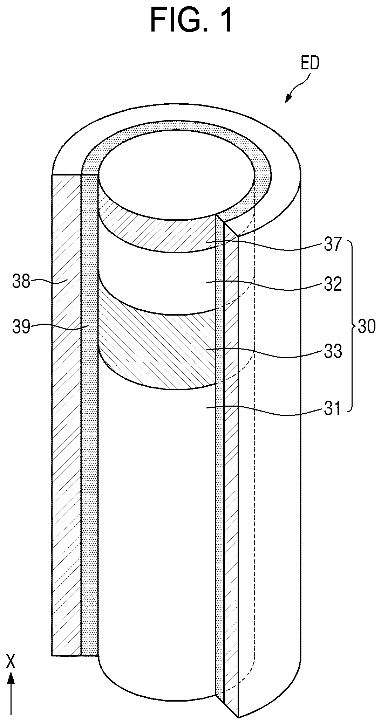

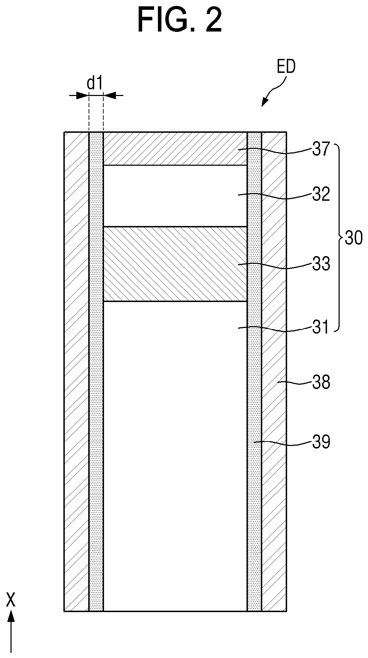

FIG. 1 is a schematic perspective view of a light emitting element in accordance with embodiments. FIG. 2 is a schematic sectional view illustrating an embodiment of the light emitting element shown in FIG. 1.

Referring to FIGS. 1 and 2, the light emitting element ED is a particletype element, and may have a rod or cylindrical shape with a selectable aspect ratio. The light emitting element ED may have a shape extending in one direction X. A length of the light emitting element ED in the one direction X may be greater than a diameter of the light emitting element ED, and an aspect ratio of the light emitting element ED may be 1.2:1 to 100:1. However, the disclosure is not limited thereto. For example, the light emitting element ED may have such as a cylinder, a rod, a wire or a tube, and have a polyprism shape such as a cube, a rectangular parallelepiped or a hexagonal prism, or have a shape which extends in the one direction X and has an outer surface partially inclined.

The light emitting element ED may have a size of nanometer scale (about 1 nm or more and less than about 1 µm) to micrometer scale (about 1 µm or more and less than about 1 mm). In an embodiment, both the diameter and the length of the light emitting element ED may have a size of nanometer scale or have a size of micrometer scale. In an embodiment, the diameter of the light emitting element ED may have a size of nanometer scale, and the length of the light emitting element ED may have a size of micrometer scale. In an embodiment, the diameter and/or the length of the light emitting element ED may have a size of nanometer scale. On the other hand, in other embodiments, the diameter and/or the length of the light emitting element ED may have a size of micrometer scale.

In an embodiment, the light emitting element ED may be an inorganic light emitting diode. The inorganic light emitting diode may include semiconductor layers. For example, the inorganic light emitting diode may include a first conductivity type (for example, an n-type) semiconductor layer, a second conductivity type (for example, a p-type) semiconductor layer, and an active semiconductor layer interposed therebetween. The active semiconductor layer may be provided with holes and electrons respectively from the first conductivity type semiconductor layer and the second conductivity type semiconductor layer, and holes and electrons, which reach the active semiconductor layer, may be combined with each other, thereby emitting light.

The light emitting element ED may include a light emitting element core 30, a first element insulating layer 39, and a second element insulating layer 38.

The light emitting element core 30 may have a shape extending in the one direction X. The light emitting element core 30 may have a rod or cylindrical shape. However, the disclosure is not limited thereto. For example, the light emitting element core 30 may have a polyprism shape such as a cube, a rectangular parallelepiped or a hexagonal prism, or have a shape which extends in the one direction X and has an outer surface partially inclined.

The light emitting element core 30 may include a first semiconductor layer 31, a second semiconductor layer 32, a light emitting layer 33, and an element electrode layer 37. The first semiconductor layer 31, the second semiconductor layer 32, the light emitting layer 33, and the element electrode layer 37 may be sequentially stacked on each other along the one direction X.

The first semiconductor layer 31 may be doped with a first conductivity type dopant. The first conductivity type may be an n-type, and the first conductivity type dopant may be Si, Ge, Sn or the like within the scope of the disclosure. For example, the first semiconductor layer 31 may be an n-type semiconductor. For example, the first semiconductor layer 31 may be n-GaN doped with n-type Si.

The second semiconductor layer 32 may be disposed to be spaced apart from the first semiconductor layer 31 with the light emitting layer 33 interposed therebetween. The second semiconductor layer 32 may be doped with a second conductivity type dopant. The second conductivity type may be a p-type, and the second conductivity type dopant may be Mg, Zn, Ca, Sr, Ba or the like within the scope of the disclosure. For example, the second semiconductor layer 32 may be a p-type semiconductor. For example, the second semiconductor layer 32 may be p-GaN doped with p-type Mg.

Each of the first semiconductor layer 31 and the second semiconductor layer 32 may be one layer, but the disclosure is not limited thereto. For example, at least one of the first semiconductor layer 31 and the second semiconductor layer 32 may further include a larger number of layers, for example, a clad layer or a tensile strain barrier reducing (TSBR) layer according to a material included in the light emitting layer 33.

The light emitting layer 33 may be disposed between the first semiconductor layer 31 and the second semiconductor layer 32. The light emitting layer 33 may include a material having a single or multiple quantum well structure. The light emitting layer 33 may emit light through combination of electron-hole pairs according to an electrical signal applied through the first semiconductor layer 31 and the second semiconductor layer 32. For example, in the case that the light emitting layer 33 emits light in a blue wavelength band, the light emitting layer 33 may include a material such as AlGaN or AlGaInN, but the disclosure is not limited thereto.

In embodiments, the light emitting layer 33 may have a structure in which a semiconductor material having a large band gap energy and a semiconductor material having a small band gap energy may be alternately stacked on each other, or include different group III to V semiconductor materials according to the wavelength band of light emitted thereof. The light emitted by the light emitting layer 36 is not limited to the light in the blue wavelength band, and the light emitting layer 36 may emit light in a red or green wavelength band in some cases.

The light emitted in the light emitting layer 33 may be emitted to not only both end surfaces of the light emitting element ED but also a side surface of the light emitting element ED. The emission direction of light emitted in the light emitting layer 33 is not limited to a specific direction.

Both end portions of the light emitting element ED may be electrically connected to an external electrode so as to apply an electrical signal to the first semiconductor layer 31 and the second semiconductor layer 32, and the element electrode layer 37 may be disposed between the second semiconductor layer 32 and the external electrode, to reduce resistance. The element electrode layer 37 may include at least one of aluminium (Al), titanium (Ti), indium (In), gold (Au), silver (Ag), Indium Tin Oxide (ITO), Indium Zinc Oxide (IZO), and Indium Tin-Zinc Oxide (ITZO). In an embodiment, the element electrode layer 37 may include a semiconductor material doped with an n-type or p-type dopant.

The element electrode layer 37 may be disposed on the second semiconductor layer 32, but the disclosure is not limited thereto. For example, a separate element electrode layer may be further disposed on the bottom of the first semiconductor layer 31.

The first element insulating layer 39 may be disposed to surround a side surface (or outer circumferential surface) of the light emitting element core 30. The first element insulating layer 39 may be disposed to surround side surfaces of the semiconductor layers (and the element electrode layer 37) included in the light emitting element core 30. The first element insulating layer 39 may be disposed to surround at least side surfaces of the first semiconductor layer 31, the light emitting layer 33, and the second semiconductor layer 32, and extend in the one direction X.

The first element insulating layer 39 surrounds of the side surface of the light emitting element core 30, and may expose both end surfaces of the light emitting element core 30. As the first element insulating layer 39 is not disposed at both the end surfaces of the light emitting element core 30 (for example, an upper surface and a bottom surface of the light emitting element core 30 in FIG. 1), the element electrode layer 37 and the first semiconductor layer 31 of the light emitting element core 30 may be exposed by the first element insulating layer 39.

In an embodiment, the first element insulating layer 39 may include an insulating material having a single crystalline structure. For example, the first element insulating layer 39 may be a single crystalline insulating layer. The insulating material included in the first element insulating layer 39 may be a material having a dielectric constant higher than a dielectric constant of the material included in each of the semiconductor layers of the light emitting element core 30. For example, the dielectric constant of the material included in the first element insulating layer 39 may be higher than the dielectric constant of the material included in each of the semiconductor layers of the light emitting element core 30. As the first element insulating layer 39 may include an insulating material having a high dielectric constant and a single crystalline structure, the first element insulating layer 39 can reduce a surface defect of the semiconductor layers included in the light emitting element core 30, which will be described later.

In an embodiment in which the first semiconductor layer 31, the second semiconductor layer 32, and the light emitting layer 33 include gallium nitride (GaN), the first element insulating layer 39 may include a single crystalline insulating material having a dielectric constant higher than a dielectric constant of the GaN. For example, the first element insulating layer 39 may include aluminium nitride (AIN) having a single crystalline structure, aluminium oxide (AlₓO_{y}) having a single crystalline structure, or the like within the scope of the disclosure.

The first element insulating layer 39 may be disposed directly on the side surface of the light emitting element core 30. The first element insulating layer 39 may be disposed to be in direct contact with the side surface of the light emitting element core 30. Therefore, an inner surface of the first element insulating layer 39 may be in contact with the side surface of the light emitting element core 30. The first element insulating layer 39 surface-treats the side surfaces of the first semiconductor layer 31, the second semiconductor layer 32, and the light emitting layer 33 of the light emitting element core 30, thereby reducing a surface defect formed on the side surfaces of the semiconductor layers of the light emitting element core 30. The surface defect formed on the side surface of the light emitting element core 30 may be a defect formed on a surface of a semiconductor layer exposed to an etchant at an outermost portion in an etching process for forming the light emitting element core 30 during manufacturing processes of the light emitting element ED, which will be described later. The surface defect causes leakage of electrons injected into the semiconductor layer or trapping of holes, thereby interrupting combination of electrons and holes. Therefore, the light efficiency of the light emitting element ED may be deteriorated. In the case that the first element insulating layer 39 having a single crystalline structure is disposed or formed directly on the side surface of the light emitting element core 30, an effect that the side surface of the light emitting element core 30 is surface-treated can be brought. For example, the dislocation density on a surface of the light emitting element core 30 can be decreased. Thus, the surface defect formed on the side surface of the light emitting element core 30 can be reduced by the first element insulating layer 39, and the element efficiency and reliability of the light emitting element ED can be improved.

Also, the first element insulating layer 39 is interposed between the light emitting element core 30 and the second element insulating layer 38, to prevent a defect formed inside the second element insulating layer 38 or to prevent an impurity from being diffused into the semiconductor layers (for example, the first semiconductor layer 31, the second semiconductor layer 32, and the light emitting layer 33) of the light emitting element core 30 from the second element insulating layer 38. For example, the first element insulating layer 39 is interposed between the light emitting element core 30 and the second element insulating layer 38, to physically separate the light emitting element core 30 and the second element insulating layer 38 from each other.

The first element insulating layer 39 may have a selectable thickness d1 in a direction perpendicular to the side surface of the light emitting element core 30. In other words, the first element insulating layer 39 may be formed within a distance corresponding to the thickness d1 from the side surface of the light emitting element core 30. The first element insulating layer 39 formed on the side surface of the light emitting element core 30 may be formed by forming a first insulating material layer 390 having a single crystalline structure on the side surface (or outer circumferential surface) of the light emitting element core 30 and removing a portion the first insulating material layer 390 as will be described later. In order for the first element insulating layer 39 to maintain the single crystalline structure, it is necessary that the thickness d1 of the first element insulating layer 39 should be formed less than or equal to a critical thickness. The "critical thickness" may be defined as a thickness with which a thin film maintains a single crystalline structure in a process of forming the thin film. In an embodiment, the thickness d1 of the first element insulating layer 39 may be included within a range of less than or equal to a critical thickness of a material included in the first element insulating layer 39. For example, in the case that the first element insulating layer 39 may include zirconium oxide (ZrOₓ), a critical thickness may be about 10 nm. The thickness d1 of the first element insulating layer 39 may be greater than about 0 nm and may be less than or equal to about 10 nm. For example, the thickness d1 of the first element insulating layer 39 may be about 5 nm. In the case that a thin film is formed with a critical thickness or less in the light emitting element core 30, a crystalline structure of the thin film becomes similar to the crystalline structure of the light emitting element core 30, and accordingly, the thin film can have a single crystalline structure. By way of example, in the case that a thin film is formed to exceed the critical thickness, the thin film has a unique (or independent) crystalline structure thereof, regardless of the crystalline structure of the light emitting element core 30. For example, the thin film may have an amorphous structure or a polycrystalline structure. For example, in the case that a thin film including zirconium oxide (ZrOₓ) is formed with a thickness of about 10 nm or less, the thin film may have crystallinity having a tetragonal structure. In the case that the thickness of the thin film exceeds 10 nm, the thin film may have an amorphous structure.

In embodiments, the first element insulating layer 39 may be an oxide insulating layer. The first element insulating layer 39 may be an insulating layer, for example, a nitride insulating layer, which may include a Group III-V semiconductor compound. However, in order to form the nitride insulating layer, a high-temperature process and a specific reaction gas may be required as compared with in case that an oxide insulating layer is formed. In other words, the oxide insulating layer can be readily formed as compared with the nitride insulating layer (or the insulating layer including the Group III-V semiconductor compound), and manufacturing cost of the light emitting element ED including the first element insulating layer 39 as the oxide insulating layer can be reduced. In the case that the second element insulating layer 38 which will be described later may include the same material as the first element insulating layer 39, the manufacturing processes of the light emitting element ED can be further simplified, and the manufacturing cost of the light emitting element ED can be further reduced.

In embodiments, the first element insulating layer 39 may include a metal oxide including two or more metal elements. For example, the two or more metal elements may be at least one selected from the group consisting of tantalum (Ta), hafnium (Hf), zirconium (Zr), lanthanum (La), silicon (Si), titanium (Ti), and aluminium (Al). For example, the first element insulating layer 39 may include zirconium oxide (ZrₓO_{y}) and aluminium oxide (AlₓO_{y}). Experimentally, in the case that the first element insulating layer 39 may include two or more metal elements, the stability of the first element insulating layer 39 can be improved as compared with the case that the first element insulating layer 39 may include one metal element.

In an embodiment, the first element insulating layer 39 may include a first metal element. The first metal element may be selected based on a physical characteristic of a base element for forming at least a portion of the light emitting element core 30. The base element may mean a material forming the first semiconductor layer 31, the second semiconductor layer 32, and the light emitting layer 33.

For example, in the case that the first semiconductor layer 31 may include n-GaN, in case that the second semiconductor layer 32 may include p-GaN, and/or in the case that the light emitting layer 33 may include a gallium-base material, the base material may be gallium. In another example, in the case that at least one of the first semiconductor layer 31, the second semiconductor layer 32, and the light emitting layer 33 may include a phosphide-base material (for example, InP), the base material may be phosphorus (P).

In embodiments, a bond-dissociation energy of the oxide formed by the first metal element may be greater than a bond-dissociation energy of the base element for forming the light emitting element core 30.

Experimentally, in the case that the bond-dissociation energy of the material forming the first element insulating layer 39 is greater than the bond-dissociation energy of the material forming the light emitting element core 30, influence on the light emitting element core 30 is minimized, and the first element insulating layer 39 can be more stably formed. Thus, in accordance with the embodiment, a risk can be prevented, that the light emission efficiency of the light emitting element ED will be deteriorated by the first element insulating layer 39.

In an embodiment, in the case that the base element is gallium, and the first semiconductor layer 31 and the second semiconductor layer 32 include GaN, a bond-dissociation energy of the oxide with respect to the first metal element may be greater than about 200 kJ/mol so as to satisfy a bond-dissociation energy condition. For example, the first metal element may be at least one selected from the group consisting of Ta, Hf, Zr, La, Si, Ti, and Al.

For example, a bond-dissociation energy of gallium nitride (GaN) may be about 200 kJ/mol. A bond-dissociation energy of silicon oxide (SiₓO_{y}) may be about 799.6 kJ/mol. A bond-dissociation energy of aluminium oxide (AlₓO_{y}) may be about 501.9 kJ/mol. A bond-dissociation energy of titanium oxide (TiₓO_{y}) may be about 666.5 kJ/mol. A bond-dissociation energy of tantalum oxide (TiₓO_{y}) may be about 839 kJ/mol. A bond-dissociation energy of hafnium oxide (HfₓO_{y}) may be about 762 kJ/mol. A bond-dissociation energy of zirconium oxide (ZrₓO_{y}) may be about 766.1 kJ/mol. A bond-dissociation energy of lanthanum oxide (LaₓO_{y}) may be about 798 kJ/mol. Accordingly, in the case that the first metal element is selected from the above-described examples, the stability of the first element insulating layer 39 can be improved as the bond-dissociation energy condition is satisfied in the case that the first semiconductor layer 31 and the second semiconductor layer 32 include GaN.

In embodiments, in the case that the bond-dissociation energy of the material forming the first element insulating layer 39 is greater than a bond-dissociation energy of a material forming an interface of the light emitting element core 30, influence on the light emitting element core 30 is minimized, and the first element insulating layer 39 can be more stably formed. An interface of the light emitting element core 30 may be formed between the light emitting element core 30 and the first element insulating layer 39. The interface of the light emitting element core 30 may mean a boundary area between the light emitting element core 30 and the first element insulating layer 39. Since the first element insulating layer 39 may include an oxide, an oxide of the base element may be formed at the interface of the light emitting element core 30. For example, in the case that the first semiconductor layer 31 and the second semiconductor layer 32 include GaN, gallium oxide may be formed at the interface of the light emitting element core 30.

In an embodiment, in the case that the base element is gallium, and the interface of the light emitting element core 30 may include gallium oxide, the bond-dissociation energy of oxide with respect to the first metal element may be greater than about 545 kJ/mol so as to satisfy the bond-dissociation energy condition. For example, the first metal element may be at least one selected from the group consisting of Ta, Hf, Zr, La, Si, and Ti. For example, a bond-dissociation energy of oxide with respect to each of the elements may be the same as described above, and a bond-dissociation energy of the gallium oxide may be about 545 kJ/mol. Accordingly, in the case that the first metal element is selected from the above-described examples, the stability of the first element insulating layer 39 can be improved as the bond-dissociation energy condition is satisfied in the case that the interface of the light emitting element core 30 may include the gallium oxide.

In embodiments, an ionic radius of the first metal element in the oxide formed by the first metal element may be greater than an ionic radius of the base element in the oxide formed by the base element. Therefore, it may be difficult for the first metal element to infiltrate into the light emitting element core 30 while passing through the interface of the light emitting element core 30.

Experimentally, in the case that an unintended metal material infiltrates into the light emitting element ED, stress may occur due to lattice mismatch between the infiltrating metal material and the light emitting element core 30. However, as the ionic radius of the first metal element is selected according to a specific reference, it is difficult for the metal material to infiltrate into the light emitting element core 30. Hence, the above-described risk can be substantially resolved.

In an embodiment, in the case that the base element is gallium, the ionic radius of the first metal element may be greater than about 0.62 Å. For example, the first metal element may include at least one of Zn, Ta, Hf, Zr, and La.

For example, an ionic radius of gallium in gallium oxide may be about 0.62 Å. An ionic radius of silicon in tantalum oxide may be about 0.64 Å. An ionic radius of silicon in hafnium oxide may be about 0.71 Å. An ionic radius of silicon in zirconium oxide may be about 0.78 Å. An ionic radius of silicon in lanthanum oxide may be about 1.032 Å. An ionic radius of zinc in zinc oxide may be in a range of about 0.74 Å to about 0.88 Å. Accordingly, in the case that the first metal element is selected from the above-described examples, an ionic radius condition is satisfied in the case that a gallium oxide structure is formed at the interface of the light emitting element core 30. Thus, a risk can be prevented, that a metal material will infiltrate into the light emitting element core 30.

In the case that the base element in the light emitting element core 30 is gallium, the first metal element may include at least one of Ta, Hf, Zr, and La. The first element insulating layer 39 may be provided, which satisfies both the bond-dissociation energy condition and the ionic radius condition.

The second element insulating layer 38 may be disposed on an outer side surface (or outer circumferential surface) of the first element insulating layer 39. The second element insulating layer 38 may be disposed to surround the outer side surface of the first element insulating layer 39. The second element insulating layer 38 may extend in the one direction X.

Similar to the first element insulating layer 39, the second element insulating layer 38 covers the side surface of the light emitting element core 30, and may expose both the end surfaces of the light emitting element core 30. In an embodiment, the second element insulating layer 38 may cover only at least a portion of the side surface of the light emitting element core 30. For example, the second element insulating layer 38 may cover only side surfaces of some or a number of semiconductor layers including the light emitting layer 33. By way of example, the second element insulating layer 38 may cover a partial area of the side surface of the element electrode layer 37, and may expose another partial area of the side surface of the element electrode layer 37.

The second element insulating layer 38 may protect the first semiconductor layer 31, the second semiconductor layer 32, and the light emitting layer 33 of the light emitting element core 30. The second element insulating layer 38 may prevent an electrical short circuit occurring in the case that an external electrode transferring an electrical signal to the light emitting element ED and the light emitting layer 33 are in direct contact with each other.

The second element insulating layer 38 may include a material having an insulating characteristic. For example, the second element insulating layer 38 may include silicon oxide (SiOₓ), silicon nitride (SiNₓ), silicon oxynitride (SiOₓN_{y}), aluminium nitride (AIN), aluminium oxide (AlₓO_{y}), titanium oxide (TiOₓ), zirconium oxide (ZrOₓ), hafnium oxide (HfOₓ), or the like within the scope of the disclosure.

In an embodiment, the second element insulating layer 38 may be an oxide insulating layer including the same material as the first element insulating layer 39. For example, the second element insulating layer 38 and the first element insulating layer 39 may include hafnium oxide (HfOₓ), zirconium oxide (ZrOₓ), or the like within the scope of the disclosure.

In an embodiment, in a direction perpendicular to the side surface of the light emitting element core 30, a thickness of the second element insulating layer 38 may be greater than the critical thickness (for example, about 10 nm). The second element insulating layer 38 can more stably protect the light emitting element core 30 (and the first element insulating layer 39) from external influence. Since the thickness of the second element insulating layer 38 is greater than the critical thickness, the second element insulating layer 38 may have an amorphous structure or a polycrystalline structure.

As described above, the light emitting element ED may include the first element insulating layer 39 disposed to surround the side surface of the light emitting element core 30 including semiconductor layers, and the first element insulating layer 39 has a single crystalline structure.

The first element insulating layer 39 having the single crystalline structure can prevent an impurity from being diffused into the semiconductor layers of the light emitting element core 30 from the second element insulating layer 38, and physically separate an internal defect of the second element insulating layer 38 and the semiconductor layers of the light emitting element core 30 from each other.

Also, the first element insulating layer 39 having the single crystalline structure surface-treats the side surfaces of the first semiconductor layer 31, the second semiconductor layer 32, and the light emitting layer 33 of the light emitting element core 30, thereby reducing a surface defect formed on the side surfaces of the semiconductor layers of the light emitting element core 30. Thus, the element efficiency and reliability of the light emitting element ED can be improved.

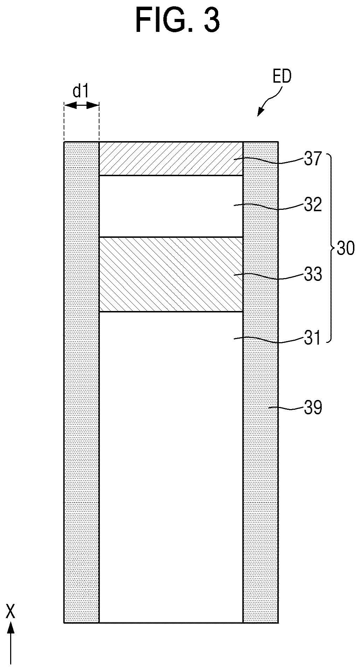

FIG. 3 is a schematic sectional view illustrating an embodiment of the light emitting element shown in FIG. 1.

Referring to FIGS. 1 to 3, a light emitting element ED shown in FIG. 3 may be different from the embodiment shown in FIG. 2, in that the light emitting element ED does not include the second element insulating layer 38.

The thickness of the first element insulating layer 39 is not limited so as to protect the semiconductor layers of the light emitting element core 30. The thickness of the first element insulating layer 39 may be about 10 nm or less, but the disclosure is not limited thereto. The thickness of the first element insulating layer 39 may vary according to a forming method thereof.

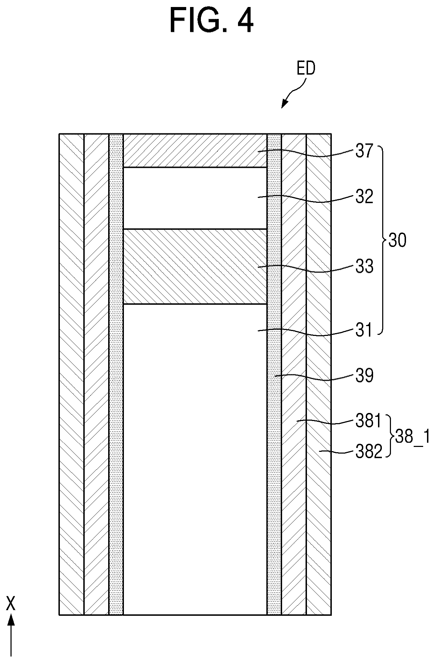

FIG. 4 is a schematic sectional view illustrating an embodiment of the light emitting element shown in FIG. 1.

Referring to FIGS. 2 and 4, a light emitting element ED shown in FIG. 4 may be different from the embodiment shown in FIG. 2, in that a second element insulating layer 38_1 may include sub-insulating layers.

The second element insulating layer 38_1 may include a first sub-insulating layer 381 and a second sub-insulating layer 382 (or a third element insulating layer).

The first sub-insulating layer 381 may be disposed on the outer side surface (or outer circumferential surface) of the first element insulating layer 39. The first sub-insulating layer 381 may be disposed to surround the outer side surface of the first element insulating layer 39. A structure and a material, which the first sub-insulating layer 381 may include, may be substantially identical respectively to the structure and the material of the second element insulating layer 38 shown in FIG. 2.

The second sub-insulating layer 382 may be disposed on an outer side surface (or outer circumferential surface) of the first sub-insulating layer 381. The second sub-insulating layer 382 may be disposed to surround the outer side surface of the first sub-insulating layer 381, and extend in the one direction X. Similar to the first sub-insulating layer 381, the second sub-insulating layer 382 covers the side surface of the light emitting element core 30, and may expose both end surfaces of the light emitting element core 30.

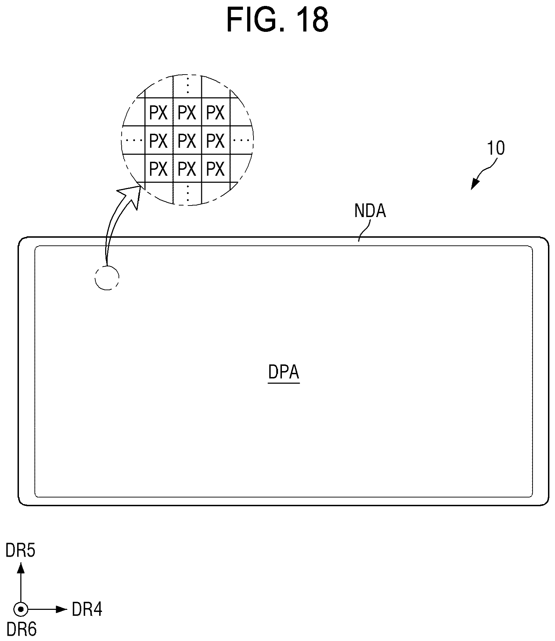

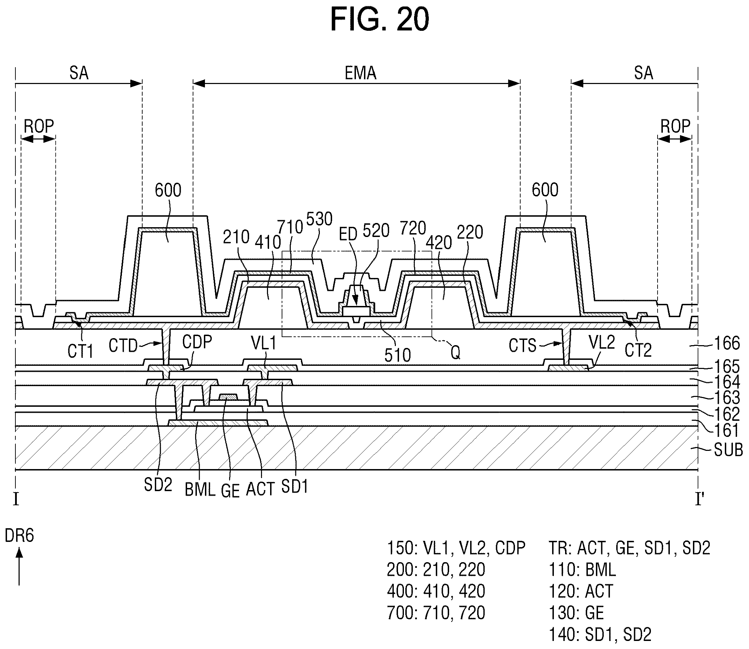

The second sub-insulating layer 382 may protect the first sub-insulating layer 381. For example, the second sub-insulating layer 382 is disposed to surround the outer side surface of the first sub-insulating layer 381, to prevent the first sub-insulating layer 381 or the light emitting element core 30 from being damaged in a process of forming a second insulating layer 520 (see FIG. 20) and/or another member of a display device 10 (see FIG. 18) during manufacturing processes of the display device 10. The second sub-insulating layer 382 may include a material constituting the second element insulating layer 38 shown in FIG. 2.

The first sub-insulating layer 381 and the second sub-insulating layer 382 may include different materials, but the disclosure is not limited thereto. For example, the first sub-insulating layer 381 and the second sub-insulating layer 382 may include the same material.

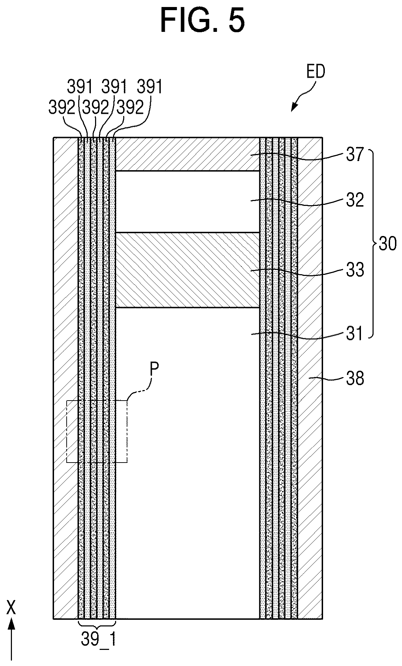

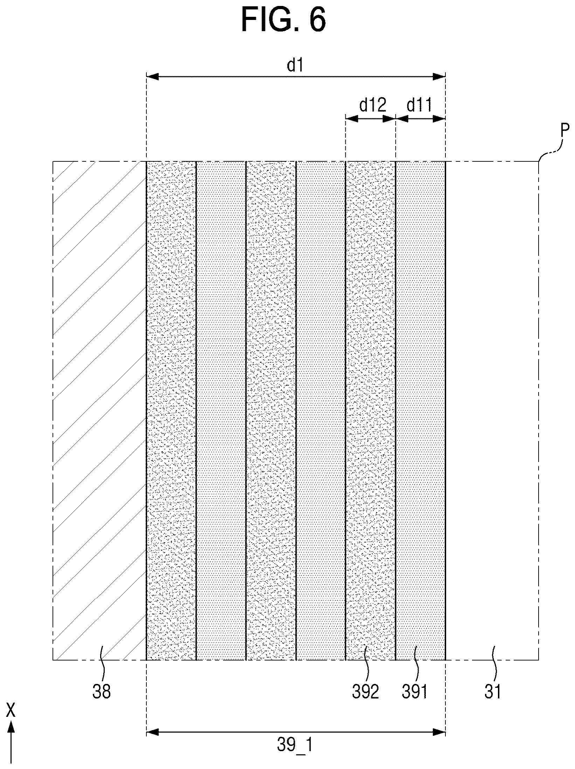

FIG. 5 is a schematic sectional view illustrating an embodiment of the light emitting element shown in FIG. 1. FIG. 6 is an enlarged view of area P shown in FIG. 5.

Referring to FIGS. 2, 5, and 6, a light emitting element ED shown in FIG. 5 may be different from the embodiment of FIG. 2, in that a first element insulating layer 39_1 of the light emitting element ED has a superlattice structure.

The first element insulating layer 39_1 may have a superlattice structure in which a first layer 391 and a second layer 392 may be alternately and repeatedly stacked on each other in a direction perpendicular to the side surface of the light emitting element core 30, and each of the first layer 391 and the second layer 392 may be an oxide insulating layer having a single crystalline structure.

In FIG. 5, it is illustrated that the first layer 391 and the second layer 392 are alternately stacked three times. However, the disclosure is not limited thereto. For example, the first element insulating layer 39_1 may have a structure in which the first layer 391 and the second layer 392 are alternately stacked a smaller number of times, and have a structure in which the first layer 391 and the second layer 392 are alternately stacked a larger number of times.

The first layer 391 is disposed directly on the side surface (or outer circumferential surface) of the light emitting element core 30, and may be disposed to surround the outer side surface of the light emitting element core 30. The second layer 392 is disposed on an outer side surface of the first layer 391, and may be disposed to surround the outer side surface of the first layer 391.

A structure (for example, a thickness) and a material of each of the first layer 391 and the second layer 392 may be substantially identical respectively to the structure and the material of the first element insulating layer 39 shown in FIG. 2. For example, the thickness of each of the first layer 391 and the second layer 392 may be about 10 nm or less. The thickness of the first layer 391 and the thickness of the second layer 392 may be the same, but the disclosure is not limited thereto. For example, the thickness of the first layer 391 and the thickness of the second layer 392 may be different from each other. The first layer 391 and the second layer 392 may include different material among the materials constituting the first element insulating layer 39.

As the first element insulating layer 39_1 has the superlattice structure, a total thickness d1 of the first element insulating layer 39_1 may become thick as compared with the case that the first element insulating layer 39_1 may include one single crystalline insulating layer. Thus, as a layer having a single crystalline structure formed in plurality, a surface defect of the light emitting element core 30 can be more efficiently reduced, and the insulation reliability of the first element insulating layer 39_1 can be improved.

In the case that the first element insulating layer 39_1 has a superlattice structure, each of the first layer 391 and the second layer 392, which the first element insulating layer 39_1 may include, may be formed through metal organic chemical vapor deposition (MOCVD) or atomic layer deposition (ALD). In an embodiment, each of the first layer 391 and the second layer 392, which the first element insulating layer 39_1 may include, may be formed through the ALD performed at low temperature.

As described above, since the first element insulating layer 39_1 has a superlattice structure in which layers may be alternately stacked on each other, the first element insulating layer 39_1 can maintain a single crystalline structure while having a thick thickness d1. Accordingly, the first element insulating layer 39_1 can efficiently prevent an impurity from being diffused into a semiconductor layer of the light emitting element core 30 from the outside or the second element insulating layer 38. Thus, the element efficiency and reliability of the light emitting element ED can be further improved.

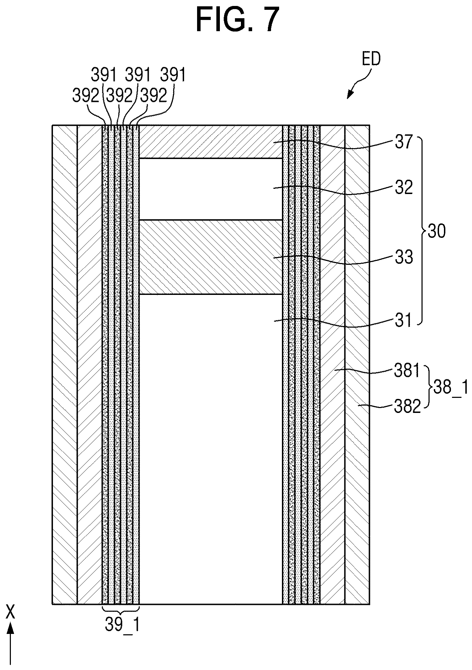

FIG. 7 is a schematic sectional view illustrating an embodiment of the light emitting element shown in FIG. 1.

Referring to FIGS. 5 and 7, a light emitting element ED shown in FIG. 7 may be different from the embodiment of shown in FIG. 5, in that a second element insulating layer 38_1 of the light emitting element ED may include sub-insulating layers.

The second element insulating layer 38_1 may include a first sub-insulating layer 381 and a second sub-insulating layer 382.

The first sub-insulating layer 381 and the second sub-insulating layer 382 have been described with reference to FIG. 4, and therefore, descriptions of the first sub-insulating layer 381 and the second sub-insulating layer 382 will be omitted.

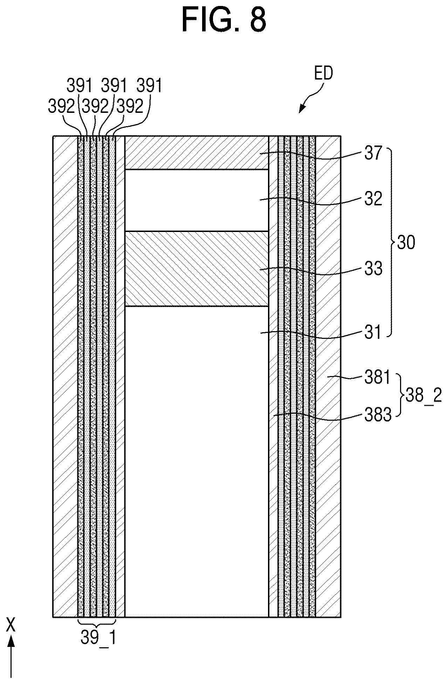

FIG. 8 is a schematic sectional view illustrating an embodiment of the light emitting element shown in FIG. 1.

Referring to FIGS. 7 and 8, a light emitting element ED shown in FIG. 8 may be different from the embodiment shown in FIG. 7, in that a second element insulating 38_2 of the light emitting element ED may include a first sub-insulating layer 381 and a third sub-insulating layer 383, and a first element insulating layer 39_1 having a superlattice structure is interposed between the first sub-insulating layer 381 and a third sub-insulating layer 383.

The third sub-insulating layer 383 may be disposed to surround the side surface of the light emitting element core 30. The third sub-insulating layer 383 may be disposed directly on the side surface of the light emitting element core 30. The third sub-insulating layer 383 may include a material having an insulating characteristic. The third sub-insulating layer 383 may include a material constituting the second element insulating layer 38 shown in FIG. 2.

The first sub-insulating layer 381 is disposed on an outer side surface of the third sub-insulating layer 383, and may be disposed to surround the outer side surface of the third sub-insulating layer 383. The first sub-insulating layer 381 may be spaced apart from the third sub-insulating layer 383.

The first element insulating layer 39_1 may be disposed between the first sub-insulating layer 381 and the third sub-insulating layer 383. The first element insulating layer 39_1 may be disposed on the outer side surface of the third sub-insulating layer 383, and the first sub-insulating layer 381 may be disposed on an outer side surface of the first element insulating layer 39_1.

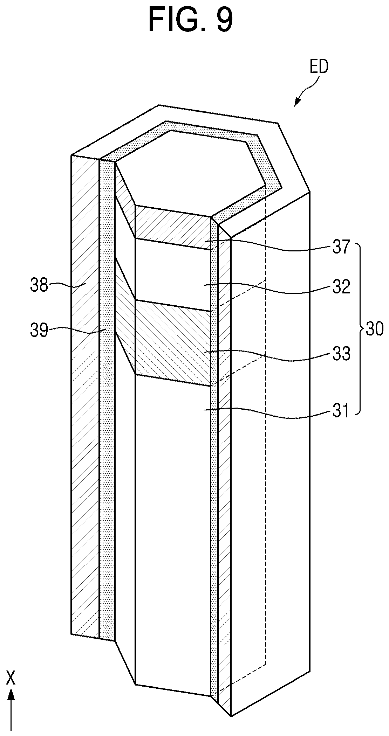

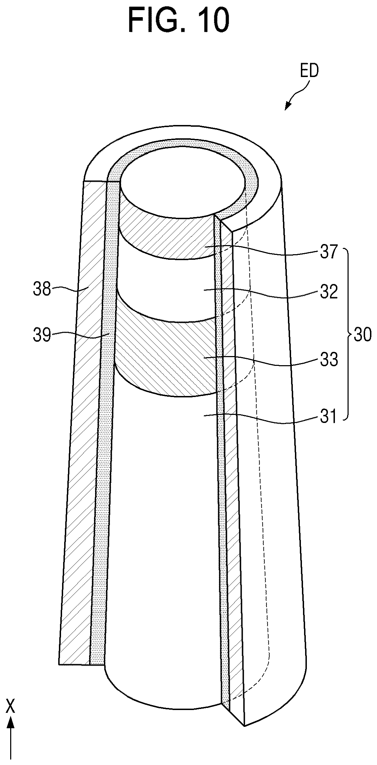

FIGS. 9 and 10 are schematic perspective views of a light emitting element in accordance with an embodiment. FIGS. 9 and 10 illustrate embodiments in which a light emitting element ED has various shapes.

Referring to FIG. 9, a light emitting element ED shown in FIG. 9 may extend in the one direction X, and have a hexagonal prism shape. A light emitting element core 30 of the light emitting element ED shown in FIG. 9 may have a hexagonal prism shape, and a first element insulating layer 39 and a second element insulating layer 38 may be disposed to surround a side surface of the light emitting element core 30.

Referring to FIG. 10, a light emitting element ED shown in FIG. 10 may extend in the one direction X, and have a truncated cone shape. A light emitting element core 30 of the light emitting element ED shown in FIG. 10 may have a truncated cone shape.

Hereinafter, manufacturing processes of a light emitting element ED will be sequentially described with reference to other drawings.

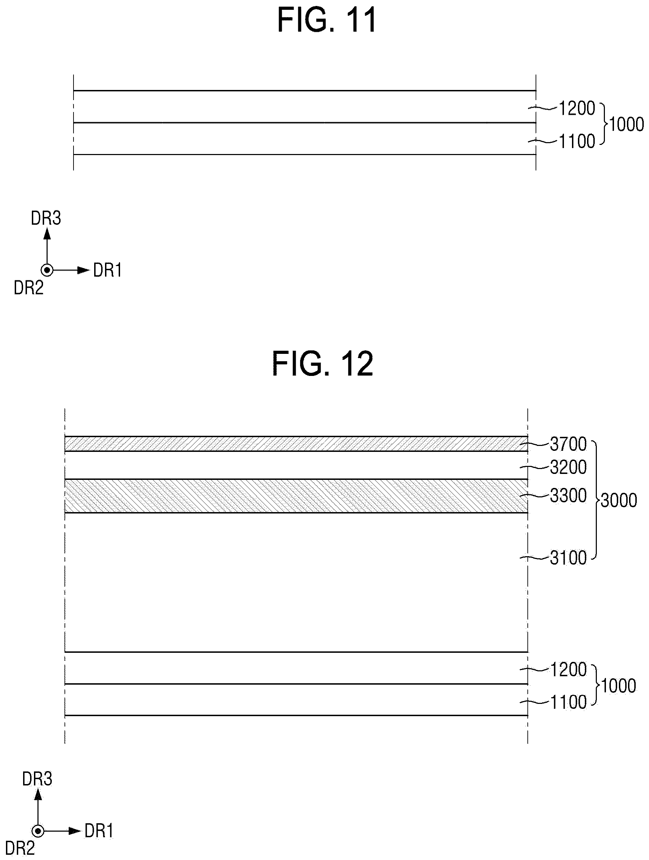

FIGS. 11 to 17 are process sectional views illustrating a manufacturing method of the light emitting element shown in FIG. 1.

Hereinafter, a first direction DR1, a second direction DR2, and a third direction DR3 are defined in drawings of an embodiment describing manufacturing processes of a light emitting element ED. The first direction DR1 and the second direction DR2 may be directions perpendicular to each other, and the third direction DR3 may be a direction perpendicular to a plane defined by the first direction DR1 and the second direction DR2.

The third direction DR3 may be a direction parallel to the one direction X as an extending direction of a light emitting element ED formed on a lower substrate 1000. In embodiments for describing the manufacturing processes of the light emitting element ED, unless otherwise stated, "upper portion" may refer to one side or a side in the third direction DR3 and represents a direction in which semiconductor layers of the light emitting element ED may be stacked on each other from one surface or a surface (or upper surface) of the lower substrate 1000, and "upper surface" may refer to a surface facing the one side or a side in the third direction DR3. It is noted that, "lower" may refer to the other side or another side in the third direction DR3, and "lower surface" may refer to a surface facing the other side in the third direction DR3.

Referring to FIG. 11, the lower substrate 1000 may be prepared.

The lower substrate 1000 may include a base substrate 1100 and a buffer material layer 1200 disposed on the base substrate 1100.

The base substrate 1100 may include a sapphire substrate (AlₓO_{y}) or a transparent substrate such as glass. However, the disclosure is not limited thereto, and the base substrate 1100 may include a conductive substrate such as GaN, SiC, ZnO, Si, GaP or GaAs.

Semiconductor layers may be formed on the base substrate 1100. The semiconductor layers may be formed by growing a seed crystal on the base substrate 1100, using an epitaxial growth method. A method of forming the semiconductor layers may include electron beam deposition, physical vapor deposition (PVD), chemical vapor deposition (CVD), plasma laser deposition (PLD), dual-type thermal evaporation, sputtering, metal organic chemical vapor deposition (MOCVD), or the like within the scope of the disclosure.

The buffer material layer 1200 may be formed on one surface or a surface (or upper surface) of the base substrate 1100. The buffer material layer 1200 may serve to decrease a lattice constant difference between the base substrate 1100 and a first semiconductor material layer 3100 (see FIG. 12) which will be described later. The buffer material layer 1200 may include an undoped semiconductor. The buffer material layer 1200 may include the same material as the first semiconductor material layer 3100 which will be described later, and may include a material undoped with a first conductivity-type dopant or a second conductivity-type dopant, for example, an n-type dopant or a p-type dopant. The buffer material layer 120 may be one layer or a layer, but the disclosure is not limited thereto. For example, the buffer material layer 1200 may include layers. The buffer material layer 1200 may be omitted according to a kind of the base substrate 1100.

Referring to FIG. 12, a first stack structure 3000 may be formed on the lower substrate 1000.

The first stack structure 3000 in which the first semiconductor material layer 3100, a light emitting material layer 3300, a second semiconductor material layer 3200, and an electrode material layer 3700 may be sequentially stacked on each other may be formed on the lower substrate 1000.

Layers included in the first stack structure 3000 may respectively correspond to the layers included in the light emitting element core 30 in accordance with embodiments. The first semiconductor material layer 3100, the light emitting material layer 3300, the second semiconductor material layer 3200, and the electrode material layer 3700 of the first stack structure 3000 may respectively correspond to the first semiconductor layer 31, the light emitting layer 33, the second semiconductor layer 32, and the element electrode layer 37, and include the same materials as the materials included in the respective layers.

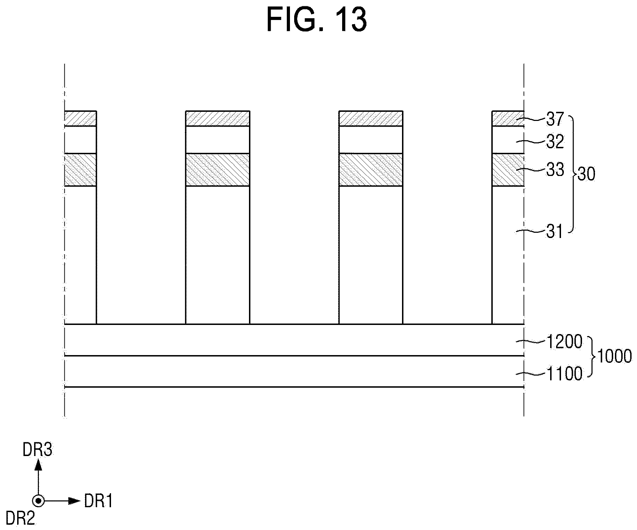

Referring to FIG. 13, light emitting element cores 30 spaced apart from each other may be formed by etching the first stack structure 3000.

The light emitting element cores 30 spaced apart from each other as shown in FIG. 13 may be formed through a process of etching the first stack structure 3000 in a direction, for example, the third direction DR3 perpendicular to a surface of the lower substrate 1000. The first stack structure 3000 may be etched using an ordinary patterning method. For example, the patterning method may be performed by forming an etch mask layer on the top of the first stack structure 3000 and etching the first stack structure 3000 in the third direction DR3 along the etch mask layer.

For example, the process of etching the first stack structure 3000 may include a dry etching method, a wet etching method, a reactive ion etching (RIE) method, an inductively coupled plasma reactive ion etching (ICP-RIE) method, or the like within the scope of the disclosure. In the case of the dry etching method, anisotropic etching may be performed to be suitable for vertical etching. In an embodiment, the etching of the first stack structure 3000 may be performed using both the dry etching method and the wet etching method.

For example, after etching in the third direction DR3 through the dry etching method, the etched sidewalls may be placed on a plane perpendicular to the upper surface of the lower substrate 1000 using a wet etching method, which is an isotropic etching method.

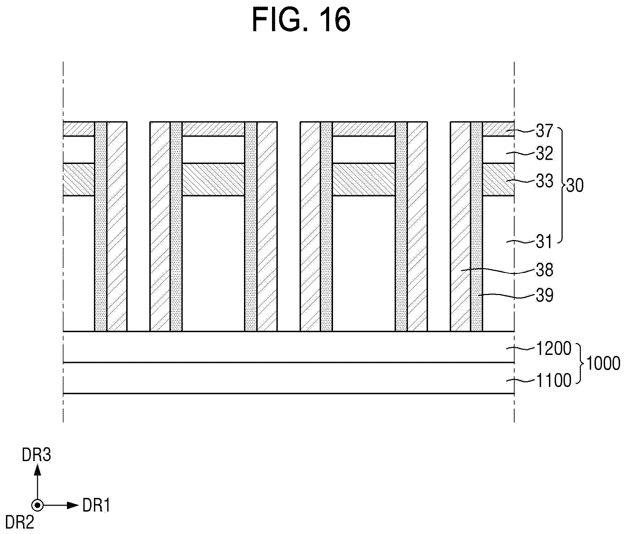

Defects caused by an etchant used in the process of etching the first stack structure 3000 may occur on surfaces of the light emitting element cores 30 formed by etching the first stack structure 3000. For example, defects of semiconductor materials may occur on surfaces of the semiconductor layers included in each of the light emitting element cores 30. The defects formed on an outer surface of the light emitting element core 30 may cause leakage of electrons injected into the semiconductor layers or trapping of holes injected into the semiconductor layers, thereby hindering a combination of the electrons and the holes, which results in deterioration of the light efficiency of the light emitting element ED. In the case that a second element insulating layer 38 (see FIG. 16) is directly formed on the outer surface of the light emitting element core 30 having the surface defects, impurities may be diffused into the semiconductor layers from the second element insulating layer 38 along a boundary between the second element insulating layer and the light emitting element core 30. Therefore, the element reliability and efficiency of the light emitting element ED may be deteriorated.

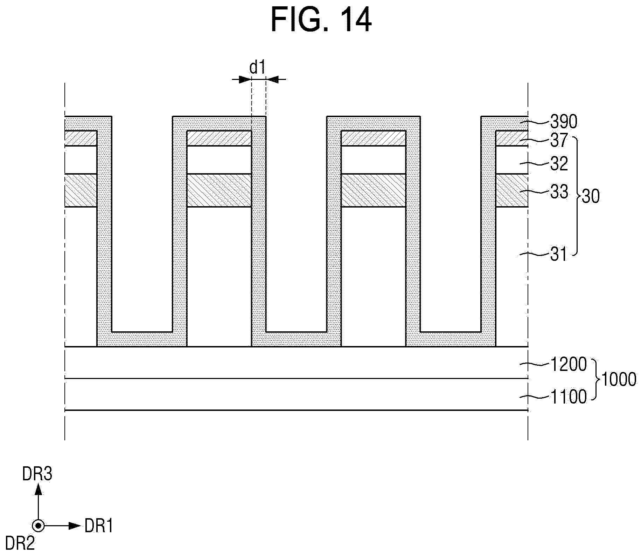

Subsequently, referring to FIG. 14, a first insulating material layer 390 may be formed on the light emitting element cores 30.

The first insulating material layer 390 having a single crystalline structure may be formed directly on side surfaces of the light emitting element cores 30 so as to decrease surface defects on outer surfaces of the semiconductor layers of the light emitting element cores 30.

The first insulating material layer 390 may be formed on the entire surface of the lower substrate 1000, to be formed not only on outer surfaces of the light emitting element cores 30, but also on upper surfaces of the lower substrate 1000, which are exposed by the light emitting element cores 30. The first insulating material layer 390 may correspond to a first element insulating layer 39 of the light emitting element ED.

In an embodiment, the first insulating material layer 390 may include a material, for example, an oxide having a single crystalline structure, which the first element insulating layer 39 may include. For example, the first insulating material layer 390 may include zirconium oxide (ZrOₓ) having a single crystalline structure.

In order to improve the efficiency of the light emitting element ED while maintaining the reliability of the light emitting element ED, the first insulating material layer 390 needs to maintain the single crystalline structure. To this end, the first insulating material layer 390 may be formed with a selectable thickness d1 on the outer surfaces of the light emitting element cores 30. The thickness d1 of the first insulating material layer 390 may be included within a range equal to or less than a critical thickness of the material included in the first insulating material layer 390. For example, in the case that the first insulating material layer 390 may include zirconium oxide (ZrOₓ), the thickness d1 of the first insulating material layer 390 may be about 10 nm or less.

The first insulating material layer 390 may be formed using atomic layer deposition, chemical vapor deposition, metal organic chemical vapor deposition, or the like within the scope of the disclosure.

In an embodiment, the first insulating material layer 390 may be formed to have the superlattice structure described with reference to FIG. 5. In the case that the first insulating material layer 390 has the superlattice structure, the first insulating material layer 390 may be formed such that layers including a compound semiconductor having a single crystalline structure may be alternately stacked on each other. Each of the layers may be formed to a thickness equal to or less than a critical thickness of a material included in the layers.

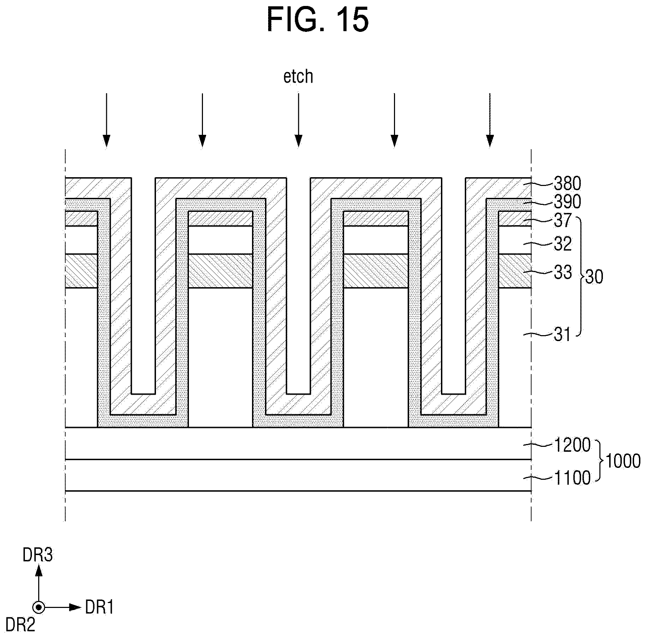

Referring to FIG. 15, a second insulating material layer 380 may be formed on the first insulating material layer 390. The second insulating material layer 380 may correspond to the second element insulating layer 38 through a subsequent process. Therefore, the second insulating material layer 380 may include a material included in the second element layer 38. For example, the second insulating material layer 380 may be formed using atomic layer deposition or chemical vapor deposition.

Referring to FIG. 16, the first insulating material layer 390 and the second insulating material layer 380 may be partially removed, thereby forming the first element insulating layer 39 and the second element insulating layer 38, which surround the side surfaces of the light emitting element cores 30.

A process of forming the first element insulating layer 39 and the second element insulating layer 38 may include an etching process of partially removing the first insulating material layer 390 and the second insulating material layer 380 so that one end surfaces of the light emitting element cores 30, for example, upper surfaces of the element electrode layers 37, are exposed. The process of partially removing the first insulating material layer 390 and the second insulating material layer 380 may be performed through a process such as dry etching as anisotropic etching, or etch-back.

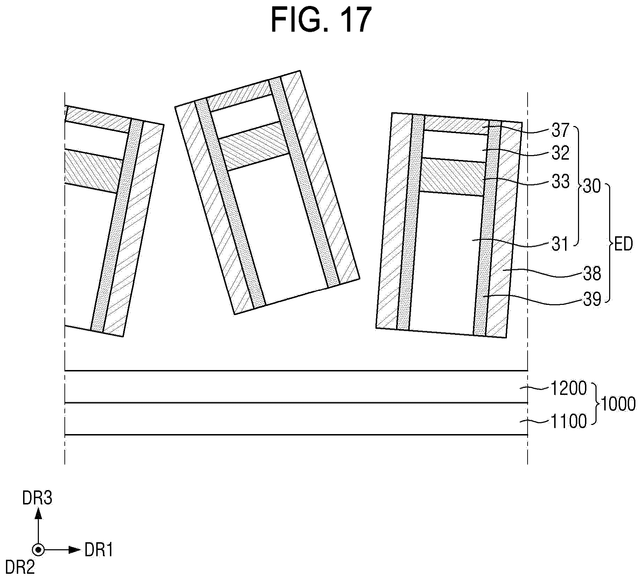

Referring to FIG. 17, light emitting elements ED may be separated from the lower substrate 1000. A process of separating the light emitting elements ED from the lower substrate 1000 is not particularly limited. For example, the process of separating the light emitting elements ED may be performed using a physical separation method, a chemical separation method, or the like within the scope of the disclosure.

FIG. 18 is a schematic plan view of a display device in accordance with an embodiment.

Referring to FIG. 18, the display device 10 may display a moving image or a still image. The display device 10 may refer to all electronic devices which provide display screens, or be applied to the electronic devices. For example, televisions, laptop computers, monitors, billboards, the Internet of Things (IoT), mobile phones, smartphones, tablet personal computers (PCs), electronic watches, smart watches, watch phones, head mounted displays, mobile communication terminals, electronic notebooks, electronic books, portable multimedia players (PMPs), navigation devices, game machines, digital cameras, camcorders, or the like, which provide display screens, may be included in the display device 10.

The display device 10 may include a display panel which provides a display screen. Examples of the display panel may include an inorganic light emitting diode display panel, an organic light emitting display panel, a quantum dot light emitting display panel, a plasma display panel, a field emission display panel, or the like within the scope of the disclosure.

Hereinafter, a case where the above-described light emitting element ED, for example, an inorganic light emitting diode display panel, is applied as an example of the display panel will be described, but the disclosure is not limited thereto, and the same example may be applied to other display panels within the scope of the disclosure.

Hereinafter, a fourth direction DR4, a fifth direction DR5, and a sixth direction DR6 are defined as shown in the drawings of one or more embodiments for describing the display device 10. The fourth direction DR4 and the fifth direction DR5 may be directions perpendicular to each other in one plane. The sixth direction DR6 may be a direction perpendicular to the plane in which the fourth direction DR4 and the fifth direction DR5 are positioned. The sixth direction DR6 is perpendicular to each of the fourth direction DR4 and the fifth direction DR5. In one or more embodiments for describing the display device 10, the sixth direction DR6 represents a thickness direction of the display device 10.

The display device 10 may have a rectangular shape including long sides and short sides, in which a length in the fourth direction DR4 is longer than a length in the fifth direction DR5 on a plane. A corner portion at which the long side and the short side of the display device 10 meet each other on a plane may be right-angled. However, the disclosure is not limited thereto, and the corner portion may also have a rounded curved shape. The shape of the display device 10 on a plane is not limited to that described above, and the display device 10 may have other shapes such as a square shape, a quadrangular shape with rounded corners (vertices), a polygonal shape, and a circular shape.

A display surface of the display device 10 may be provided on one side or a side in the sixth direction DR6, which is the thickness direction. In embodiments for describing the display device 10, unless otherwise stated, "upper portion" may refer to one side or a side in the sixth direction DR6 and represent a display direction, and "upper surface" may refer to a surface facing the one side or side in the sixth direction DR6. It is noted that, "lower portion" may refer to another side in the sixth direction DR6 and represent an opposite direction to the display direction, and "lower surface" may refer to a surface facing the other side in the sixth direction DR6. It is noted that, "left", "right", "upper", and "lower" refer to directions when the display device 10 is viewed on a plane. For example, "right side" refers to one side or a side in the fourth direction DR4, "left side" refers to the other side in the fourth direction DR4, "upper side" refers to one side or a side in the fifth direction DR5, and "lower side" refers to the other side or another side in the fifth direction DR5.

The display device 10 may include a display area DPA and a non-display area NDA. The display area DPA is an area in which a screen is displayed, and the non-display area NDA is an area in which the screen is not displayed.

A shape of the display area DPA may correspond to the shape of the display device 10. For example, the shape of the display area DPA may have a rectangular shape on a plane, which is similar to the overall shape of the display device 10. The display area DPA may occupy substantially the center of the display device 10.

The display area DPA may include pixels PX. The pixels PX may be arranged (or disposed) in a matrix direction. A shape of each pixel PX may be a rectangular or square shape on a plane. However, the disclosure is not limited thereto, and the shape of each pixel PX may be a rhombic shape in which each side is inclined with respect to one direction or a direction. The pixels PX may be alternately arranged in a stripe type or a PENTILE^{™} type.

The non-display area NDA may be disposed at the periphery of the display area DPA. The non-display area NDA may entirely or partially surround the display area DPA. In an embodiment, the display area DPA may have a rectangular shape, and the non-display area NDA may be disposed adjacent to four sides of the display area DPA. The non-display area NDA may constitute a bezel of the display device 10. Lines, circuit drivers, and/or a pad part on which an external device is mounted, which are included in the display device 10, may be disposed in the non-display area NDA.

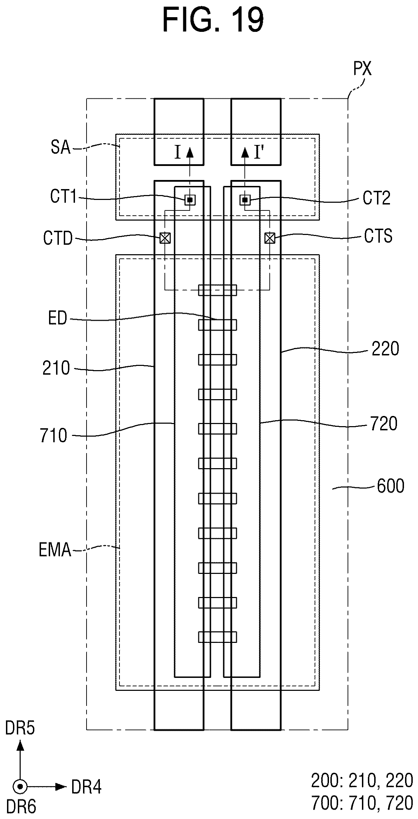

FIG. 19 is a schematic plan view illustrating an embodiment of a pixel included in the display device shown in FIG. 18. FIG. 20 is a schematic sectional view illustrating an embodiment of the pixel taken along line I-I' shown in FIG. 19.

Referring to FIG. 19, each pixel PX of the display device 10 may include an emission area EMA and a non-emission area. The emission area EMA may be defined as an area in which light emitted from light emitting elements ED is emitted, and the non-emission area may be defined as an area in which no light is emitted as the light emitted from the light emitting elements ED does not arrive at the area.

The emission area EMA may include an area in which the light emitting elements ED are arranged and an adjacent area thereof. Also, the emission area EMA may further include an area in which the light emitted from the light emitting elements ED is reflected or refracted by other members and emitted.

Each pixel PX may further include a sub-area SA disposed in the non-emission area. The light emitting elements ED may not be disposed in the sub-area SA. The sub-area SA may be disposed at an upper side of the emission area EMA on a plane in one pixel PX.

The sub-area SA may be disposed between emission areas EMA of pixels PX arranged adjacent to each other in the fifth direction DR5. The sub-area SA may include an area in which an electrode layer 200 and a contact electrode 700 are electrically connected to each other through contact parts CT1 and CT2.

The sub-area SA may include a separation part ROP. The separation part ROP of the sub-area SA may be an area in which first electrodes 210 and second electrodes 220 included in electrode layers 200, which are included in respective pixels PX adjacent to each other along the fifth direction DR5, are separated from each other.

Referring to FIGS. 19 and 20, the display device 10 may include a substrate SUB, a circuit element layer disposed on the substrate SUB, and a light emitting element layer disposed on the circuit element layer.

The substrate SUB may be an insulating substrate. The substrate SUB may be made of an insulating material such as glass, quartz, or a polymer resin. The substrate SUB may be a rigid substrate, but may also be a flexible substrate capable of being bent, folded, rolled, and/or the like within the scope of the disclosure.

The circuit element layer may be disposed on the substrate SUB. The circuit element layer may include a bottom metal layer 110, a semiconductor layer 120, a first conductive layer 130, a second conductive layer 140, a third conductive layer 150, and insulating layers.

The bottom metal layer 110 is disposed on the substrate SUB. The bottom metal layer 110 may include a light blocking pattern BML. The light blocking pattern BML may be disposed below a transistor TR to cover at least a channel region of an active layer ACT of the transistor TR. However, the disclosure is not limited thereto, and the light blocking pattern BML may be omitted.

The bottom metal layer 110 may include a material capable of blocking light. For example, the bottom metal layer 110 may be formed of an opaque metal material capable of blocking transmission of the light.

A buffer layer 161 may be disposed over the bottom metal layer 110. The buffer layer 161 may cover the entire surface of the substrate SUB on which the bottom metal layer 110 is disposed. The buffer layer 161 may serve to protect transistors from moisture infiltrating through the substrate SUB which is vulnerable to moisture infiltration.

The semiconductor layer 120 may be disposed on the buffer layer 161. The semiconductor layer 120 may include the active layer ACT of the transistor TR. The active layer ACT of the transistor TR may be disposed while overlapping the light blocking pattern BML of the bottom metal layer 110.

The semiconductor layer 120 may include polycrystalline silicon, single crystalline silicon, an oxide semiconductor, and/or the like within the spirit and the scope of the disclosure.

The active layer ACT of the transistor TR may include doped regions doped with an impurity and a channel region therebetween.

A gate insulating layer 162 may be disposed over the semiconductor layer 120.

The first conductive layer 130 may be disposed on the gate insulating layer 162. The first conductive layer 130 may include a gate electrode GE of the transistor TR. The gate electrode GE may be disposed to overlap the channel region of the active layer ACT in the sixth direction DR6.

A first interlayer insulating layer 163 may be disposed over the first conductive layer 130. The first interlayer insulating layer 163 may be disposed to cover the gate electrode GE. The first interlayer insulating layer 163 may function as an insulating layer between the first conductive layer 130 and other layers disposed thereon, and protect the first conductive layer 130.

The second conductive layer 140 may be disposed on the first interlayer insulating layer 163. The second conductive layer 140 may include a drain electrode SD1 of the transistor TR and a source electrode SD2 of the transistor TR.

The drain electrodes SD1 and the source electrode SD2 of the transistor TR may be electrically connected to both end areas of the active layer ACT of the transistor TR through contact holes penetrating the first interlayer insulating layer 163 and the gate insulating layer 162, respectively. The source electrode SD2 of the transistor TR may be electrically connected to the light blocking pattern BML of the bottom metal layer 110 through another contact hole penetrating the first interlayer insulating layer 163, the gate insulating layer 162, and the buffer layer 161.

A second interlayer insulating layer 164 may be disposed over the second conductive layer 140. The second interlayer insulating layer 164 may be disposed to cover the drain electrode SD1 of the transistor TR and the source electrode SD2 of the transistor TR. The second interlayer insulating layer 164 may function as an insulating layer between the second conductive layer 140 and other layers disposed thereon, and protect the second conductive layer 140.

The third conductive layer 150 may be disposed on the second interlayer insulating layer 164. The third conductive layer 150 may include a first voltage line VL1, a second voltage line VL2, and a conductive pattern CDP.

The first voltage line VL1 may overlap at least a portion of the drain electrode SD1 of the transistor TR in the sixth direction DR6. A high-potential voltage (or first power voltage) supplied to the transistor TR may be applied to the first voltage line VL1.

The second voltage line VL2 may be electrically connected to a second electrode 220 through a second electrode contact hole CTS penetrating a via layer 166 and a passivation layer 165, which will be described later. A low-potential voltage (or second power voltage) lower than the high-potential voltage supplied to the first voltage line VL1 may be applied to the second voltage line VL2. For example, the high-potential voltage (or first power voltage) supplied to the transistor TR may be applied to the first voltage line VL1, and the low-potential voltage (or second power voltage) lower than the high-potential voltage supplied to the first voltage line VL1 may be applied to the second voltage line VL2.

The conductive pattern CDP may be electrically connected to the source electrode SD2 of the transistor TR. The conductive pattern CDP may be electrically connected to the source electrode SD2 of the transistor TR through a contact hole penetrating the second interlayer insulating layer 164. Also, the conductive pattern CDP may be electrically connected to a first electrode 210 through a first electrode contact hole CTD penetrating the via layer 166 and the passivation layer 165, which will be described later. The transistor TR may transfer the first power voltage applied from the first voltage line VL1 to the first electrode 210 through the conductive pattern CDP.

The passivation layer 165 may be disposed over the third conductive layer 150. The passivation layer 165 may be disposed to cover the third conductive layer 150. The passivation layer 165 may serve to protect the third conductive layer 150.

Each of the buffer layer 161, the gate insulating layer 162, the first interlayer insulating layer 163, the second interlayer insulating layer 164, and the passivation layer 165, which are described above, may include an inorganic insulating material, and may one inorganic layer or inorganic layers. For example, the inorganic layer may include at least one of silicon oxide (SiOₓ), silicon nitride (SiNₓ), and silicon oxynitride (SiOₓN_{y}).

The via layer 166 may be disposed on the passivation layer 165. The via layer 166 may include an inorganic insulating material, for example, an organic material such as polyimide (PI). The via layer 166 may serve to planarize a surface. Therefore, an upper surface (or surface) of the via layer 166 may be a substantially flat surface regardless of a shape of a pattern disposed below the via layer 166 or the presence or absence of the pattern.

The light emitting element layer may be disposed on the circuit element layer. The light emitting element layer may be disposed on the via layer 166. The light emitting element layer may include a first bank 400, an electrode layer 200, a first insulating layer 510, a second bank 600, light emitting element ED, and a contact electrode 700.

The first bank 400 may be disposed on the via layer 166 in the emission area EMA. The first bank 400 may be disposed directly on one surface or a surface of the via layer 166. The first bank 400 may have a structure in which at least a portion thereof protrudes in the sixth direction DR6 with respect to the one surface or a surface of the via layer 166. The protruding portion of the first bank 400 may have inclined side surfaces. The first bank 400 may serve to change a traveling direction of light emitted from the light emitting elements ED and traveling toward the side surfaces of the first bank 400 into an upward direction (for example, a display direction).

The first bank 400 may include a first sub-bank 410 and a second sub-bank 420, which are spaced apart from each other. The first sub-bank 410 and the second sub-bank 420, which are spaced apart from each other, may provide a space in which the light emitting elements ED are disposed and assist in a role of reflective partition walls which change the traveling direction of the light emitted from the light emitting elements ED into the display direction.

In FIG. 20, it is illustrated that the side surfaces of the first bank 400 are in a linear inclined shape. However, the disclosure is not limited thereto. For example, the side surfaces (or outer surfaces) of the first bank 400 may have a curved semicircular or semielliptical shape.

The first bank 400 may include an organic insulating material such as polyimide (PI).

The electrode layer 200 may have a shape extending in one direction or a direction, and be disposed to traverse the emission area EMA and the sub-area SA. The electrode layer 200 may transfer, to the light emitting elements ED, an electrical signal applied from the circuit element layer to allow the light emitting elements ED to emit light. Also, the electrode layer 200 may be used to generate an electric field used in a process of aligning the light emitting elements ED.

The electrode layer 200 may be disposed on the first bank 400 and the via layer 166 exposed by the first bank 400. In the emission area EMA, the electrode layer 200 may be disposed on the first bank 400. In the non-emission area, the electrode layer 200 may be disposed on the via layer 166 exposed by the first bank 400.

The electrode layer 200 may include the first electrode 210 and the second electrode 220. The first electrode 210 and the second electrode 220 may be spaced apart from each other.

The first electrode 210 may be disposed at the left side of each pixel PX on a plane. The first electrode 210 may have a shape extending in the fifth direction DR5 on a plane. The first electrode 210 may be disposed to traverse the emission area EMA and the sub-area SA.

The first electrode 210 extends in the fifth direction DR5 on a plane, and may be separated from a first electrode 210 of a pixel PX adjacent in the fifth direction DR5 at the separation part of the sub-area SA.

The second electrode 220 may be spaced apart from the first electrode 210 in the fourth direction DR4. The second electrode 220 may be disposed at the right side of each pixel PX on a plane. The second electrode 220 may have a shape extending in the fifth direction DR5 on a plane. The second electrode 220 may be disposed to traverse the emission area EMA and the sub-area SA. The second electrode 220 extends in the fifth direction DR5 on a plane, and may be separated from a second electrode 220 of a pixel adjacent in the fifth direction DR5 at the separation part ROP of the sub-area SA.

In the emission area EMA, the first electrode 210 may be disposed over the first sub-bank 410, and the second electrode 220 may be disposed over the second sub-bank 420. The first electrode 210 may extend outward from the first sub-bank 410 to be also disposed on the via layer 166 exposed by the first sub-bank 410. Similarly, the second electrode 220 may extend outward from the second sub-bank 420 to be also disposed on the via layer 166 exposed by the second sub-bank 420. The first electrode 210 and the second electrode 220 may be spaced apart from each other while facing each other in a separation area between the first sub-bank 410 and the second sub-bank 420. The via layer 166 may be exposed in the area in which the first electrode 210 and the second electrode 220 are spaced apart from each other while facing each other.

The first electrode 210 may be spaced apart from a first electrode 210 of another pixel PX adjacent in the fifth direction DR5 with the separation part ROP interposed therebetween in the sub-area SA. Similarly, the second electrode 220 may be spaced apart from a second electrode 220 of another pixel PX adjacent in the fifth direction DR5 with the separation part ROP interposed therebetween in the sub-area SA. Therefore, the first electrode 210 and the second electrode 220 may expose the via layer 166 at the separation part ROP of the sub-area SA.

The first electrode 210 may be electrically connected to the conductive pattern CDP of the circuit element layer through the first electrode contact hole CTD penetrating the via layer 166 and the passivation layer 165. The first electrode 210 may be in contact with an upper surface of the conductive pattern CDP exposed by the first electrode contact hole CTD. The first power voltage applied from the first voltage line VL1 may be transferred to the first electrode 210 through the conductive pattern CDP.

The second electrode 220 may be electrically connected to the second voltage line VL2 of the circuit element layer through the second electrode contact hole CTS penetrating the via layer 166 and the passivation layer 165. Specifically, the second electrode 220 may be in contact with an upper surface of the second power line VL2 exposed by the second electrode contact hole CTS. The second power voltage applied from the second voltage line VL2 may be transferred to the second electrode 220.

The electrode layer 200 may include a conductive material having high reflectivity. For example, the electrode layer 200 may include a metal such as silver (Ag), copper (Cu), or aluminium (Al), or include an alloy including aluminium (Al), nickel (Ni), lanthanum (La), or the like, as the material having the high reflectivity. The electrode layer 200 may reflect the light emitted from the light emitting elements ED and traveling toward the side surfaces of the first bank 400 in the upward direction of each pixel PX.

However, the disclosure is not limited thereto, and the electrode layer 200 may further include a transparent conductive material. For example, the electrode layer 200 may include a material such as ITO, IZO, or ITZO. In an embodiment, the electrode layer 200 may have a structure in which one or more layers made of the transparent conductive material and one or more layers made of the metal having high reflectivity may be stacked on each other, or be formed as one layer including the transparent conductive material and the metal having high reflectivity. For example, the electrode layer 200 may have a stacked structure such as ITO/Ag/ITO, ITO/Ag/IZO, or ITO/Ag/ITZO/IZO.

The first insulating layer 510 may be disposed on the via layer 166 on which the electrode layer 200 is formed. The first insulating layer 510 may protect the electrode layer 200 and insulate the first electrode 210 and the second electrode 220 from each other.

The first insulating layer 510 may include an inorganic insulating material. The first insulating layer 510 made of an inorganic material may have a surface shape which reflects a pattern shape of the electrode layer 200 disposed on the bottom thereof. For example, the first insulating layer 510 may have a stepped structure according to a shape of the electrode layer 200 disposed on the bottom of the first insulating layer 510. Specifically, the first insulating layer 510 may include a stepped structure in which a portion of an upper surface thereof is recessed in the area in which the first electrode 210 and the second electrode 220 are spaced apart from each other while facing each other. Therefore, a height of an upper surface of the first insulating layer 510 disposed on the top of the first electrode 210 and the top of the second electrode 220 may be higher than a height of an upper surface of the first insulating layer 510 disposed on an upper portion of the via layer 166 on which the first electrode 210 and the second electrode 220 are not disposed. In this specification, a relative comparison of a height of an upper surface of an arbitrary layer may be made by a height measured from a flat reference surface (for example, an upper surface of the via layer 166) which does not have a lower stepped structure.

The first insulating layer 510 may include a first contact part CT1 exposing a portion of an upper surface of the first electrode 210 in the sub-area SA and a second contact part CT2 exposing a portion of an upper surface of the second electrode 220 in the sub-area SA. The first electrode 210 may be electrically connected to a first contact electrode 710 through the first contact part CT1 penetrating the first insulating layer 510 in the sub-area SA, and the second electrode 220 may be electrically connected to a second contact electrode 720 through the second contact part CT2 penetrating the first insulating layer 510 in the sub-area SA.

The second bank 600 may be disposed on the first insulating layer 510. The second bank 600 may be disposed in a lattice pattern including portions extending in the fourth direction DR4 and the fifth direction DR5 on a plane.

The second bank 600 may be disposed throughout boundaries between the respective pixels PX to divide adjacent pixels PX, and divide the emission area EMA and the sub-area SA. Also, the second bank 600 may be formed to have a height higher than a height of the first bank 400, to enable an ink in which the light emitting elements ED are dispersed not to be mixed in adjacent pixels PX but to be jetted into the emission area EMA in an inkjet printing process for aligning the light emitting elements ED during manufacturing processes of the display device 10.

The light emitting elements ED may be disposed in the emission area EMA. The light emitting elements ED may not be disposed in the sub-area SA.

The light emitting elements ED may be disposed on the first insulating layer 510 between the first sub-bank 410 and the second sub-bank 420. The light emitting elements ED may be disposed between the first electrode 210 and the second electrode 220 on the first insulating layer 510.

The light emitting elements ED may have a shape extending in one direction or a direction, and be arranged such that both end portions thereof are respectively placed on the first electrode 210 and the second electrode 220. For example, the light emitting elements ED may be arranged such that one end portions thereof are placed on the first electrode 210 and the other end portions thereof are placed on the second electrode 220.

A length of each light emitting element ED (for example, a length of the light emitting element ED in the fourth direction DR4 in the drawings) may be smaller than a shortest distance between the first sub-bank 410 and the second sub-bank 420 spaced apart from each other in the fourth direction DR4. Also, the length of each light emitting element ED may be greater than a shortest distance between the first electrode 210 and the second electrode 220 spaced apart from each other in the fourth direction DR4. As a distance between the first sub-bank 410 and the second sub-bank 420 in the fourth direction DR4 is greater than the length of each light emitting element ED and a distance between the first electrode 210 and the second electrode 220 in the fourth direction DR4 is smaller than the length of each light emitting element ED, the light emitting elements ED may be disposed in an area between the first sub-bank 410 and the second sub-bank 420 such that both ends thereof are placed on the first electrode 210 and the second electrode 220, respectively.

The light emitting elements ED may be disposed to be spaced apart from each other along the fifth direction DR5 in which the first electrode 210 and the second electrode 220 extend, and be aligned substantially parallel to each other.

A second insulating layer 520 may be disposed on the light emitting elements ED. The second insulating layer 520 may be partially disposed on the light emitting elements ED to expose both end portions of the light emitting elements ED. The second insulating layer 520 may be disposed to partially surround outer surfaces of the light emitting elements ED, and be disposed not to cover one end portions and the other end portions of the light emitting elements ED.

Portions of the second insulating layer 520, which are disposed on the light emitting elements ED, may be disposed to extend in the fifth direction DR5 on the first insulating layer 510 on a plane, to form a linear or island-shaped pattern in each pixel PX. The second insulating layer 520 may protect the light emitting elements ED and fix the light emitting elements ED in the manufacturing processes of manufacturing the display device 10. Also, the second insulating layer 520 may be disposed to fill separation spaces between the light emitting elements ED and the first insulating layer 510 on the bottom thereof.

The contact electrode 700 may be disposed on the second insulating layer 520. The contact electrode 700 may be disposed on the first insulating layer 510 on which the light emitting elements ED are arranged. The contact electrode 700 may include the first contact electrode 710 and the second contact electrode 720, which are spaced apart from each other.

The first contact electrode 710 may be disposed on the first electrode 210 in the emission area EMA. The first contact electrode 710 may have a shape extending in the fifth direction DR5 on the first electrode 210. The first contact electrode 710 may be in contact with each of the first electrode 210 and one end portion of the light emitting element ED.

The first contact electrode 710 may be in contact with the first electrode 210 exposed by the first contact part CT1 penetrating the first insulating layer 510 in the sub-area SA, and be in contact with the one end portion of the light emitting element ED in the emission area EMA. For example, the first contact electrode 710 may serve to electrically connect the first electrode 210 and the one end portion of the light emitting element ED to each other.

The second contact electrode 720 may be disposed on the second electrode 220 in the emission area EMA. The second contact electrode 720 may have a shape extending in the fifth direction DR5 on the second electrode 220. The second contact electrode 720 may be in contact with each of the second electrode 220 and the other end portion of the light emitting element ED.

The second contact electrode 720 may be in contact with the second electrode 220 exposed by the second contact part CT2 penetrating the first insulating layer 510 in the sub-area SA, and be in contact with the other end portion of the light emitting element ED in the emission area EMA. For example, the second contact electrode 720 may serve to electrically connect the second electrode 210 and the other end portion of the light emitting element ED to each other.

The first contact electrode 710 and the second contact electrode 720 may be spaced apart from each other on the light emitting element ED. Specifically, the first contact electrode 710 and the second contact electrode 720 may be spaced apart from each other with the second insulating layer 520 interposed therebetween. The first contact electrode 710 and the second contact electrode 720 may be electrically insulated from each other.

The first contact electrode 710 and the second contact electrode 720 may include the same material. For example, each of the first contact electrode 710 and the second contact electrode 720 may include a conductive material. For example, the first contact electrode 710 and the second contact electrode 720 may include ITO, IZO, ITZO, aluminium (Al), or the like within the scope of the disclosure. In an example, each of the first contact electrode 710 and the second contact electrode 720 may include a transparent conductive material. As each of the first contact electrode 710 and the second contact electrode 720 include the transparent conductive material, light emitted from the light emitting element ED may travel toward the first electrode 210 and the second electrode 220 while being transmitted through the first contact electrode 710 and the second contact electrode 720, and be reflected on surfaces of the first electrode 210 and the second electrode 220.

The first contact electrode 710 and the second contact electrode 720 may include the same material, and be formed in the same layer. The first contact electrode 710 and the second contact electrode 720 may be simultaneously formed through the same process.

A third insulating layer 530 may be disposed over the contact electrode 700. The third insulating layer 530 may cover the light emitting element layer disposed therebelow. The third insulating layer 530 may cover the first bank 400, the electrode layer 200, the first insulating layer 510, the light emitting elements ED, and the contact electrode 700. The third insulating layer 530 may be disposed over the second bank 600, to also cover the second bank 600.

The third insulating layer 530 may serve to protect the light emitting element layer therebelow from foreign materials such as moisture/oxygen and/or dust particles. The third insulating layer 530 may serve to protect the first bank 400, the electrode layer 200, the first insulating layer 510, the light emitting elements ED, and the contact electrode 700.

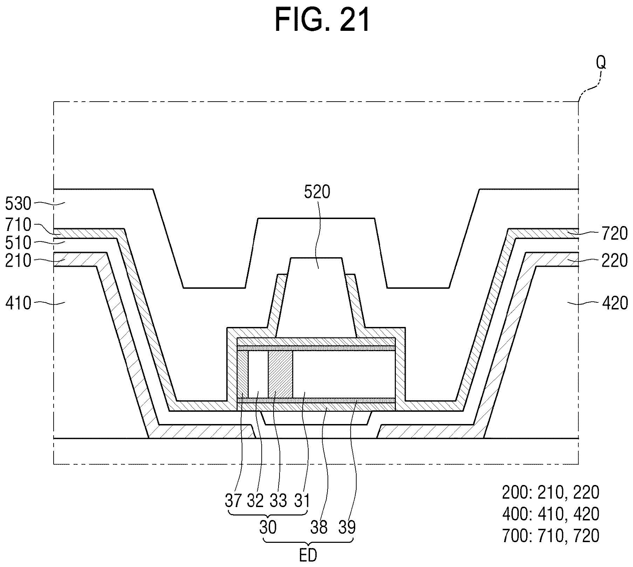

FIG. 21 is an enlarged schematic sectional view illustrating an embodiment of area Q shown in FIG. 20.

Referring to FIG. 21, the light emitting element ED may be disposed such that an extending direction of the light emitting element ED is parallel to one surface or a surface of the substrate SUB. Semiconductor layers included in the light emitting element ED may be sequentially disposed along a direction parallel to an upper surface of the substrate SUB (or an upper surface of the via layer 166). For example, a first semiconductor layer 31, a light emitting layer 33, and a second semiconductor layer 32 of the light emitting element ED may be sequentially stacked on each other to be parallel to the upper surface of the substrate SUB.

The light emitting element ED may be disposed such that one end portion thereof is placed on the first electrode 210 and the other end portion thereof is placed on the second electrode 220. However, the disclosure is not limited thereto, and the light emitting element ED may be disposed such that one end portion thereof is placed on the second electrode 220 and the other end portion thereof is placed on the first electrode 210.

The second insulating layer 520 may be disposed on the light emitting element ED. The second insulating layer 520 may surround an outer surface of the light emitting element ED. The second insulating layer 520 may be disposed on a second element insulating layer 38 of the light emitting element ED, and surround an outer surface of the second element insulating layer 38 of the light emitting element ED facing the display direction DR6.

In an area in which the light emitting element ED is disposed, the second insulating layer 520 may be disposed to surround the outer surface of the light emitting element ED (specifically, the second element insulating layer 38 of the light emitting element ED). In an area in which the light emitting element ED is not disposed, the second insulating layer 520 may be disposed on the first insulating layer 510 exposed by the light emitting element ED.

The first contact electrode 710 may be in contact with one end or an end of the light emitting element ED exposed by the second insulating layer 520. The first contact electrode 710 may be disposed to surround one end surface or an end surface of the light emitting element ED exposed by the second insulating layer 520. The first contact electrode 710 may be in contact with the second element insulating layer 38 and an element electrode layer 37 of the light emitting element ED.

The second contact electrode 720 may be in contact with the other end of the light emitting element ED exposed by the second insulating layer 520. The second contact electrode 720 may be disposed to surround the other end surface of the light emitting element ED exposed by the second insulating layer 520. The second contact electrode 720 may be in contact with the second element insulating layer 38 and the first semiconductor layer 31 of the light emitting element ED.

The first contact electrode 710 and the second contact electrode 720 may be spaced apart from each other with the second insulating layer 520 interposed therebetween. The first contact electrode 710 and the second contact electrode 720 may expose at least a portion of an upper surface of the second insulating layer 520.

The first contact electrode 710 and the second contact electrode 720 may be formed in the same layer and include the same material. For example, the first contact electrode 710 and the second contact electrode 720 may be simultaneously formed through one mask process. Accordingly, an additional mask process for forming the first contact electrode 710 and the second contact electrode 720 is not required, and thus the efficiency of the manufacturing processes of the display device 10 may be improved.

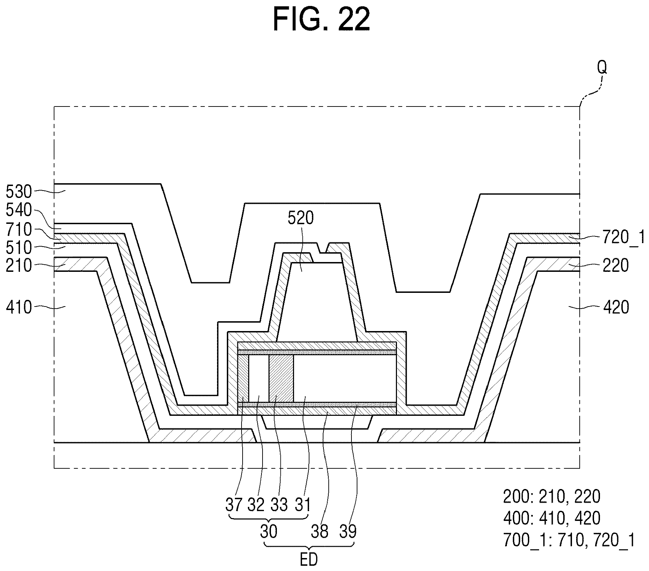

FIG. 22 is an enlarged schematic sectional view illustrating an embodiment of the area Q shown in FIG. 20.

Referring to FIGS. 21 and 22, the embodiment shown in FIG. 22 may be different from the embodiment shown in FIG. 21, in that a contact electrode 700_1 shown in FIG. 22 may include a first contact electrode 710 and a second contact electrode 720_1, which are formed in different layers with a fourth insulating layer 540 interposed therebetween.

The first contact electrode 710 may be disposed on the first electrode 210 and one end portion of the light emitting element ED. The first contact electrode 710 may extend toward the second insulating layer 520 from the one end portion of the light emitting element ED to also be disposed on one sidewall of the second insulating layer 520 and an upper surface of the second insulating layer 520. The first contact electrode 710 is disposed on the upper surface of the second insulating layer 520, but may expose at least a portion of the upper surface of the second insulating layer 520.

The fourth insulating layer 540 may be disposed over the first contact electrode 710. The fourth insulating layer 540 may be disposed to completely cover the first contact electrode 710. The fourth insulating layer 540 is disposed to completely cover the one sidewall and the upper surface of the second insulating layer 520, but may not be disposed on the other sidewall of the second insulating layer 520. One end portion of the fourth insulating layer 540 may be aligned parallel to the other sidewall of the second insulating layer 520.

The second contact electrode 720_1 may be disposed on the second electrode 220 and the other end portion of the light emitting element ED. The second contact electrode 720_1 may extend toward the second insulating layer 520 from the other end portion of the light emitting element ED to also be disposed on the other sidewall of the second insulating layer 520 and an upper surface of the fourth insulating layer 540.

The third insulating layer 530 may be disposed over the fourth insulating layer 540 and the second contact electrode 720_1. The third insulating layer 530 may be disposed over the fourth insulating layer 540 and the second contact electrode 720_1 to cover the fourth insulating layer 540 and the second contact electrode 720_1.

As the first contact electrode 710 and the second contact electrode 720_1 are formed in different layers, and the fourth insulating layer 540 is interposed between the first contact electrode 710 and the second contact electrode 720_1, a process of the display device 10 is added, and therefore, the manufacturing process efficiency of the display device 10 may be deteriorated. However, the reliability of the display device 10 can be improved. As the first contact electrode 710 and the second contact electrode 720_1 are formed in different layers, and the fourth insulating layer 540 is further disposed between the first contact electrode 710 and the second contact electrode 720_1, a problem in that the first contact electrode 710 and the second contact electrode 720_1 are short-circuited during the processes of manufacturing the display device 10 can be minimized.

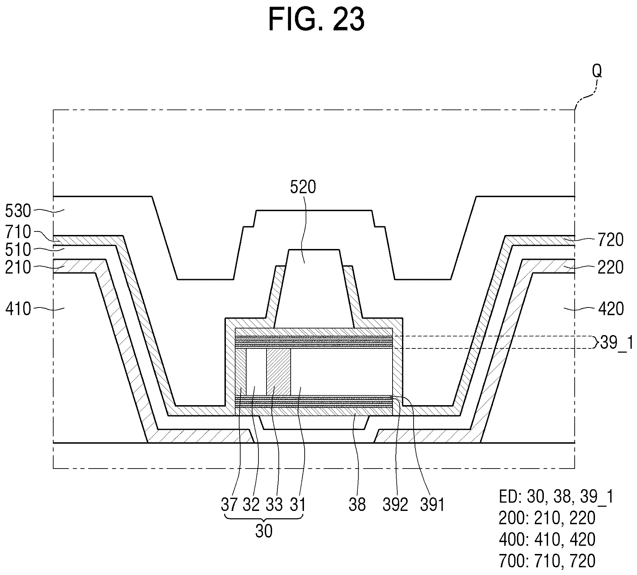

FIG. 23 is an enlarged schematic sectional view illustrating an embodiment of the area Q shown in FIG. 20.

Referring to FIGS. 21 and 23, the embodiment shown in FIG. 23 may be different from the embodiment shown in FIG. 21, in that the light emitting element ED of FIG. 5 is applied.

The light emitting element ED may include a first element insulating layer 39 having a superlattice structure. In the light emitting element ED disposed on the first electrode 210 and the second electrode 220, the first element insulating layer 39, in which first layers 391 and second layers 392 may be alternately and repeatedly stacked on each other, may be interposed between the light emitting element core 30 and the second element insulating layer 38.

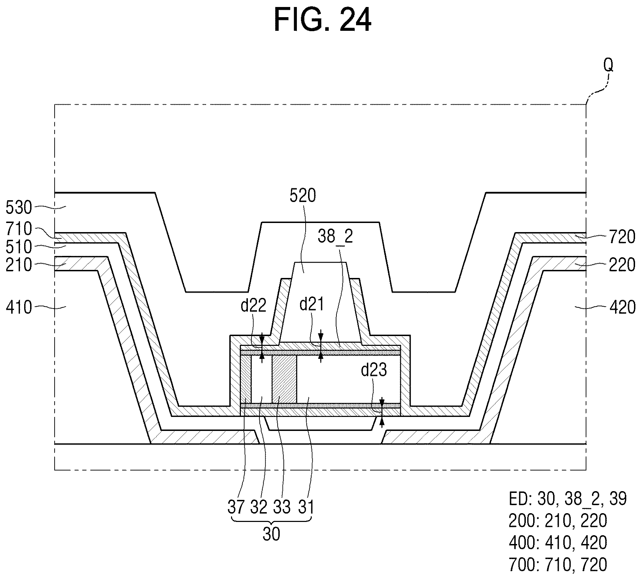

FIG. 24 is an enlarged schematic sectional view illustrating an embodiment of the area Q shown in FIG. 20.

Referring to FIGS. 21 and 24, the embodiment shown in FIG. 24 may be different from the embodiment shown in FIG. 21, in that a thickness of a second element insulating layer 38_2 of the light emitting element ED varies for each area.

The second element insulating layer 38_2 of the light emitting element ED, which is aligned between the first electrode 210 and the second electrode 220, may have different thicknesses for different areas.

The second element insulating layer 38_2 located (or disposed) above the light emitting element core 30 on a section traversing the light emitting element ED may have a first thickness d21 in an area overlapping the second insulating layer 520. The second element insulating layer 38_2 located above the light emitting element core 30 on the section traversing the light emitting element ED may have a second thickness d22 thinner than the first thickness d21 in an area not overlapping the second insulating layer 520. The second element insulating layer 38_2 located below the light emitting element core 30 in the section traversing the light emitting element ED may have a third thickness d23 equal to the first thickness d21. A portion of the second element insulating layer 38_2 located above the light emitting element core 30 may face the display direction, and another portion of the second element insulating layer 38_2 located below the light emitting element core 30 may face the first insulating layer 510.

For example, the second element insulating layer 38_2 which overlaps the second insulating layer 520 and is located above the light emitting element core 30 and the second element insulating layer 38_2 located below the light emitting element core 30 may have the same thickness, and the second element insulating layer 38_2 which does not overlap the second insulating layer 520 and is located above the light emitting element core 30 may have a thickness thinner than a thickness of the second element insulating layer 38_2 which overlaps the second insulating layer 520 and is located above the light emitting element core 30. This may be formed by etching a portion of the second element insulating layer 38_2 in the processes of manufacturing the display device 10.

While the above has been described with reference to preferred embodiments of the present invention, it will be understood by those skilled in the art or having ordinary knowledge in the relevant technical field that various modifications and changes may be made to the present invention without departing from the spirit and scope of the invention as set forth in the claims below. Accordingly, the technical scope of the present invention should not be limited to the detailed description set forth in the specification, but should be defined by the claims.

## Claims

1. A light emitting element comprising:
a light emitting element core including:
a first semiconductor layer;
a second semiconductor layer spaced apart from the first semiconductor layer; and
a light emitting layer disposed between the first semiconductor layer and the second semiconductor layer; and
a first element insulating layer surrounding a side surface of the light emitting element core,
wherein the first element insulating layer is an oxide insulating layer having a single crystalline structure.

2. The light emitting element of claim 1, wherein a thickness of the first element insulating layer in a direction perpendicular to the side surface of the light emitting element core is greater than about 0 nm and is about 10 nm or less.

3. The light emitting element of claim 1, wherein the first element insulating layer includes a metal oxide including two or more metal elements.

4. The light emitting element of claim 3, wherein the two or more metal elements are at least one selected from the group consisting of Ta, Hf, Zr, La, Si, Ti, and Al.

5. The light emitting element of claim 1, wherein
the first element insulating layer includes a first metal element,
at least a portion of the light emitting element core includes a base element, and
a bond-dissociation energy of an oxide with respect to the first metal element is greater than a bond-dissociation energy of an oxide with respect to the base element.

6. The light emitting element of claim 5, wherein an ionic radius of the first metal element in the oxide is greater than an ionic radius of the base element in the oxide.

7. The light emitting element of claim 1, wherein the first element insulating layer is directly disposed on the side surface of the light emitting element core.

8. The light emitting element of claim 1, further comprising:
a second element insulating layer surrounding an outer side surface of the first element insulating layer.

9. The light emitting element of claim 8, wherein the second element insulating layer is an oxide insulating layer having an amorphous structure or a polycrystalline structure.

10. The light emitting element of claim 9, wherein the first element insulating layer and the second element insulating layer include a same material.

11. The light emitting element of claim 9, further comprising:
a third element insulating layer surrounding an outer side surface of the second element insulating layer.

12. The light emitting element of claim 1, wherein
the first element insulating layer has a superlattice structure in which a first layer and a second layer including different materials are alternately multi-stacked, and
the first layer and the second layer are stacked in a direction perpendicular to the side surface of the light emitting element core.

13. The light emitting element of claim 12, wherein each of the first layer and the second layer is an oxide insulating layer having a single crystalline structure.

14. The light emitting element of claim 13, wherein a thickness of each of the first layer and the second layer in a direction perpendicular to the side surface of the light emitting element core is greater than about 0 nm and is about 10 nm or less.

15. A display device comprising:
a first electrode and a second electrode disposed on a substrate, the first electrode and the second electrode being spaced apart from each other; and
a light emitting element disposed between the first electrode and the second electrode, wherein
the light emitting element includes:
a light emitting element core including:
a first semiconductor layer;
a second semiconductor layer spaced apart from the first semiconductor layer; and
a light emitting layer disposed between the first semiconductor layer and the second semiconductor layer; and
a first element insulating layer surrounding a side surface of the light emitting element core, and
the first element insulating layer is an oxide insulating layer having a single crystalline structure.

16. The display device of claim 15, wherein the first element insulating layer has a thickness which is greater than about 0 nm and is about 10 nm or less in a direction perpendicular to the side surface of the light emitting element core.

17. The display device of claim 15, wherein the first element insulating layer includes a metal oxide including two or more metal elements.

18. The display device of claim 17, wherein the two or more metal elements are at least one selected from the group consisting of Ta, Hf, Zr, La, Si, Ti, and Al.

19. The display device of claim 15, wherein
the light emitting element further includes a second element insulating layer surrounding an outer side surface of the first element insulating layer, and
the second element insulating layer is an oxide insulating layer having an amorphous structure or a polycrystalline structure.

20. The display device of claim 15, wherein
the first element insulating layer has a superlattice structure in which a first layer and a second layer including different materials are alternately multi-stacked,
the first layer and the second layer are stacked in a direction perpendicular to the side surface of the light emitting element core, and
each of the first layer and the second layer is an oxide insulating layer having a single crystalline structure.
